# EUROPEAN PATENT APPLICATION

(11) **EP 4 694 644 A1**
(43) Date of publication of application: **11.02.2026**
(21) Application number: 25193811.4
(22) Date of filing: 04.08.2025
(51) Int. Cl.: H10K 59/122, H10K 59/131, H10K 59/80, H10K 59/35

(54) **ELECTRONIC DEVICE**

(30) Priority: 05.08.2024 KR 20240104047
(71) Applicant: Samsung Display Co., Ltd., Yongin-si, Gyeonggi-do 17113 (KR)
(72) Inventor: KANG, KI NYENG, 17113 Yongin-si (KR); KWON, DOHYUN, 17113 Yongin-si (KR); KIM, HYOENG-KI, 17113 Yongin-si (KR); PARK, JONGHEE, 17113 Yongin-si (KR); PARK, Chanju, 17113 Yongin-si (KR); BYUN, JIN-SU, 17113 Yongin-si (KR); SONG, DOKEUN, 17113 Yongin-si (KR); LEE, SUNGEUN, 17113 Yongin-si (KR); JEONG, YU-GWANG, 17113 Yongin-si (KR); CHOI, DAEWON, 17113 Yongin-si (KR)
(74) Representative: Taor, Simon Edward William

(57) **Abstract**

An electronic device includes a substrate which includes a display region having light emitting regions and a non-light emitting region disposed between the light emitting regions, a pixel unit including pixels each having a light emitting element, and disposed on the substrate, a power line crossing the pixel unit, and a partition wall surrounding each of the pixels, and including a first partition wall pattern and a second partition wall pattern disposed on the first partition wall pattern, which include different metals from each other. The partition wall is divided into a contact region electrically connected to the power line through a contact-hole and a normal region other than the contact region. A shape of an upper surface of the first partition wall pattern in the normal region is different from a shape of an upper surface of the first partition wall pattern in the contact region.

## Description

### CROSS-REFERENCE TO RELATED APPLICATION(S)

This application claims priority to and benefits of Korean Patent Application No. 10-2024-0104047, filed on August 5, 2024, in the Korean Intellectual Property Office.

### BACKGROUND

### 1. Technical field

The disclosure generally relates to an electronic device, and more specifically to, an electronic device with improved display quality.

### 2. Description of the Related Art

In general, an electronic device which provides images to a user, such as a smart phone, a digital camera, a notebook computer, a navigation system, and a smart television, includes an electronic device for displaying the images. The electronic device generates images, and provides the generated images to a user through a display screen.

The electronic device includes multiple pixels for generating images and multiple lines electrically connected to the pixels. The pixels are driven by receiving driving signals through the lines.

Medium-and-large-sized electronic devices with a large area such as tablets and smart TVs may have a difference in driving voltage delivered to each pixel, and thus, are required to have a design that compensates for the difference.

### SUMMARY

The disclosure provides an electronic device capable of providing a uniform driving voltage to pixels.

An embodiment of the disclosure, an electronic device includes a substrate including a display region having light emitting regions and a non-light emitting region disposed between the light emitting regions, a pixel unit including pixels each having a light emitting element, and disposed on the substrate, a power line crossing the pixel unit, and disposed on the substrate, and a partition wall having partition wall openings overlapping the light emitting regions, disposed in the non-light emitting region to surround each of the pixels, and including a first partition wall pattern and a second partition wall pattern disposed on the first partition wall pattern, wherein the partition wall is divided into a contact region connected to the power line through a contact-hole and a normal region other than the contact region, wherein a shape of an upper surface of the first partition wall pattern in the normal region is different from a shape of an upper surface of the first partition wall pattern in the contact region.

In an embodiment, the upper surface of the first partition wall pattern in the contact region may have a concave shape in a direction from the upper surface of the first partition wall pattern toward a lower surface of the first partition wall pattern, and a portion of the second partition wall pattern may have a shape corresponding to the shape of the upper surface of the first partition wall pattern.

In an embodiment, in the normal region, the upper surface of the first partition wall pattern may be flat.

In an embodiment, in the contact region, the upper surface of the first partition wall pattern may have a trench recessed in a direction from the upper surface of the first partition wall pattern toward the lower surface of the first partition wall pattern, wherein on a cross-section, the trench may have an inverted trapezoidal shape, and the portion of the second partition wall pattern has a shape corresponding to a shape of the trench.

In an embodiment, the first partition wall may include aluminum, and the second partition wall may include titanium.

In an embodiment, a width of the first partition wall pattern may be smaller than a width of the second partition wall pattern, and a thickness of the first partition wall pattern may be greater than a thickness of the second partition wall pattern.

In an embodiment, each of the light emitting elements may include a first electrode, a second electrode disposed on the first electrode, and a common layer disposed between the first electrode and the second electrode, wherein the second electrode may be commonly disposed in the light emitting elements.

In an embodiment, the second electrode overlapping the partition wall may be in contact with a side surface of the first partition wall pattern, a lower surface of the second partition wall pattern exposed from the first partition wall pattern, and a side surface of the second partition wall pattern.

In an embodiment, the side surface of the first partition wall pattern may be oxidized not to be conductive.

In an embodiment, the electronic device may further include a dummy pattern disposed on the second partition wall pattern and covered by the second electrode, wherein the dummy pattern and the common layer includes a same material.

In an embodiment, the electronic device may further include a protective layer disposed between the second partition wall and the dummy pattern wherein the protective layer may include an inorganic material.

In an embodiment, a portion of the second partition wall pattern exposed from the first partition wall pattern may include a tip portion bent in a downward direction.

In an embodiment, a thickness of the second electrode disposed on the common layer may be greater than a thickness of the second electrode surrounding the partition wall.

In an embodiment, the partition wall may include a first insulating pattern disposed in a lower portion of the first partition wall pattern and a second insulating pattern disposed between the first insulating pattern and the first partition wall pattern, wherein the first insulating pattern and the second insulating pattern may include different materials from each other.

In an embodiment, the first insulating pattern may include at least one of indium zinc oxide, indium gallium zinc oxide, or indium tin oxide, and the second insulating pattern may include at least one of silicon oxide, silicon oxynitride, or silicon nitride.

In an embodiment, a width of the first insulating pattern may be smaller than a width of the second insulating pattern.

In an embodiment, the electronic device may further include a third partition wall pattern disposed between the first partition wall pattern and the second insulating pattern, and the third partition wall pattern and the second partition wall pattern includes a same material.

In an embodiment, the electronic device may further include an interlayer insulating layer in which the power line is disposed, an inter-insulating layer disposed on the interlayer insulating layer and covering the power line, and a pixel defining layer in which the first insulating pattern is disposed, and openings corresponding to the light emitting regions are defined, and which is disposed on the inter-insulating layer.

In an embodiment, the contact-hole may be defined by a first contact-hole overlapping a portion of the power line and through which the inter-insulating layer passes, and a second contact-hole overlapping the first contact-hole and through which the pixel defining layer passes, and, in the contact region, an opening overlapping the contact-hole may be defined in the first insulating pattern and the second insulating pattern.

In an embodiment, the first partition wall pattern may be disposed in the opening and the contact-hole to be electrically connected to the power line.

According to an aspect, there is provided an electronic device as set out in claim 1. Additional features are set out in claims 2 to 15.

### BRIEF DESCRIPTION OF THE DRAWINGS

The accompanying drawings are included to provide a further understanding of the disclosure, and are incorporated in and constitute a part of this specification. The drawings illustrate embodiments of the disclosure and, together with the description, serve to explain principles of the disclosure. In the drawings:
FIG. 1A is a schematic perspective view of an electronic device according to an embodiment of the disclosure;
FIG. 1B is a schematic block diagram of an electronic device according to an embodiment of the disclosure;
FIG. 2 is a schematic cross-sectional view of an electronic device according to an embodiment of the disclosure;
FIG. 3 is a schematic cross-sectional view of a display panel according to an embodiment of the disclosure;
FIG. 4A is a schematic diagram of a display module according to an embodiment of the disclosure;
FIG. 4B is a schematic diagram of an equivalent circuit of one of pixels illustrated in FIG. 4A;
FIG. 5A is a schematic plan view of a pixel unit according to an embodiment of the disclosure;
FIG. 5B is a schematic plan view of a pixel unit according to an embodiment of the disclosure;
FIG. 6 is a schematic cross-sectional view taken along line I-I' of FIG. 5A;
FIG. 7 is a schematic cross-sectional view taken along line II-II' of FIG. 5A;
FIG. 8 is a schematic cross-sectional view taken along line III-III' of FIG. 5A;
FIG. 9 is a schematic cross-sectional view of a partition wall overlapping a contact region according to an embodiment of the disclosure;
FIG. 10 is a schematic cross-sectional view of a partition wall overlapping a contact region according to an embodiment of the disclosure;
FIG. 11 is a schematic cross-sectional view of a partition wall overlapping a contact region according to an embodiment of the disclosure;
FIG. 12 is a schematic cross-sectional view of a partition wall overlapping a contact region according to an embodiment of the disclosure;
FIGS. 13A, 13B, 13C, 13D, 13E, 13F, and 13G are schematic cross-sectional views illustrating a method for manufacturing a display panel according to an embodiment of the disclosure;
FIG. 14 is a schematic block diagram illustrating a display system according to an embodiment of the disclosure; and
FIG. 15 is a schematic view showing an example of a smart watch including an electronic device according to an embodiment of the disclosure.

### DETAILED DESCRIPTION OF THE EMBODIMENTS

In the disclosure, in case that an element (or a region, a layer, a portion, and the like) is referred to as being "on,'' "connected to," or "coupled to" another element, it means that the element may be disposed (or directly disposed) on/connected to/coupled to the other element, or that a third element may be disposed therebetween.

Like reference numerals refer to like elements. Also, in the drawings, the thickness, the ratio, and the dimensions of elements are exaggerated for an effective description of technical contents. The term "and/or" includes all combinations of one or more of which associated components may define.

The terms "first," "second," and the like may be used for describing various elements, but the elements should not be construed as being limited by the terms. The terms are used only for the purpose of distinguishing one component from the other. For example, a first element may be referred to as a second element, and a second element may also be referred to as a first element in a similar manner without departing the scope of rights of the disclosure. The terms of a singular form may include plural forms unless the context clearly indicates otherwise.

Terms such as "below," "lower," "above," "upper," and the like are used to describe the relationship of the components shown in the drawings. The terms are used as a relative concept and are described with reference to the direction indicated in the drawings.

It should be understood that the term "comprise," or "have" is intended to specify the presence of stated features, integers, steps, operations, elements, components, or combinations thereof in the disclosure, but do not preclude the presence or addition of one or more other features, integers, steps, operations, elements, components, or combinations thereof.

Unless otherwise defined, all terms (including technical and scientific terms) used herein have the same meaning as commonly understood by one of ordinary skill in the art to which the disclosure pertains. It is also to be understood that terms such as terms defined in commonly used dictionaries should be interpreted as having meanings consistent with the meanings in the context of the related art, and should not be interpreted in too ideal a sense or an overly formal sense unless explicitly defined herein.

Hereinafter, embodiments of the disclosure will be described with reference to the accompanying drawings.

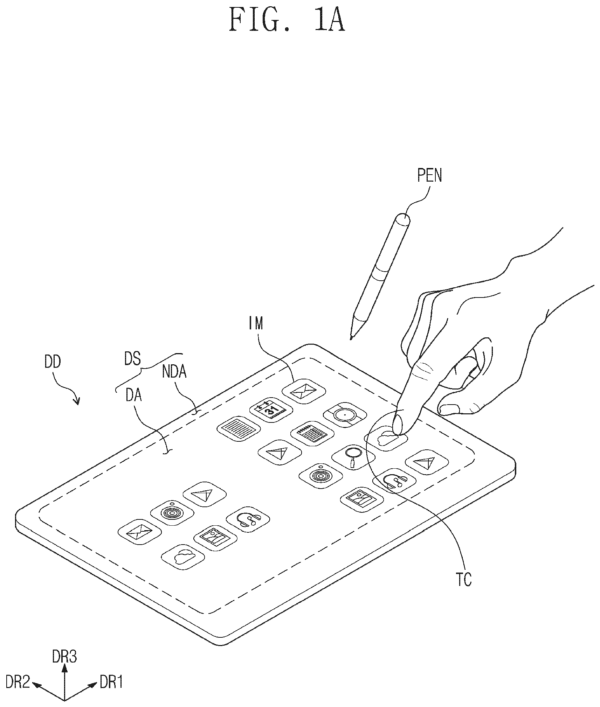

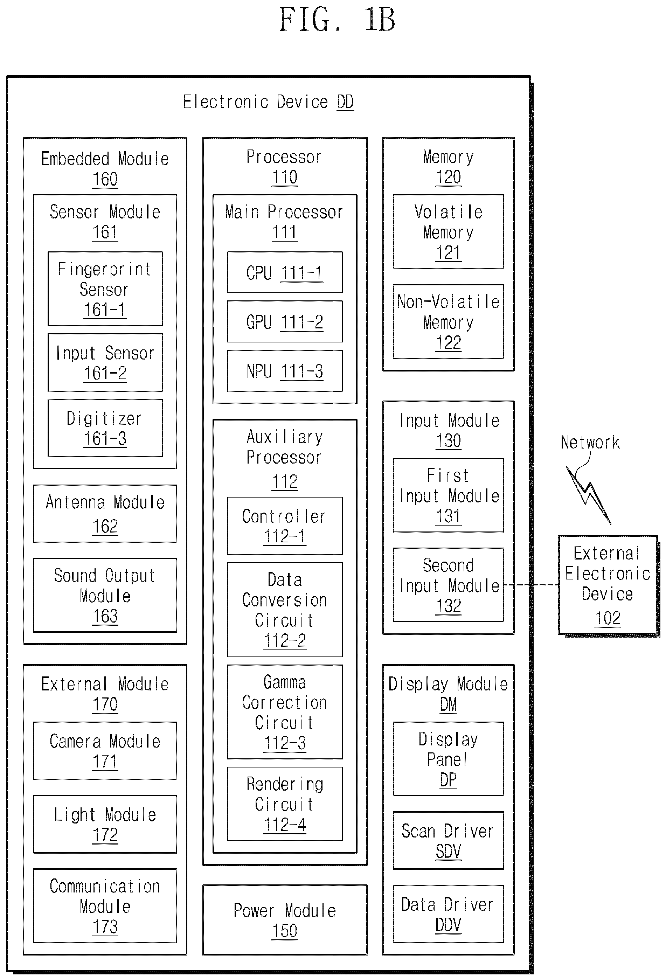

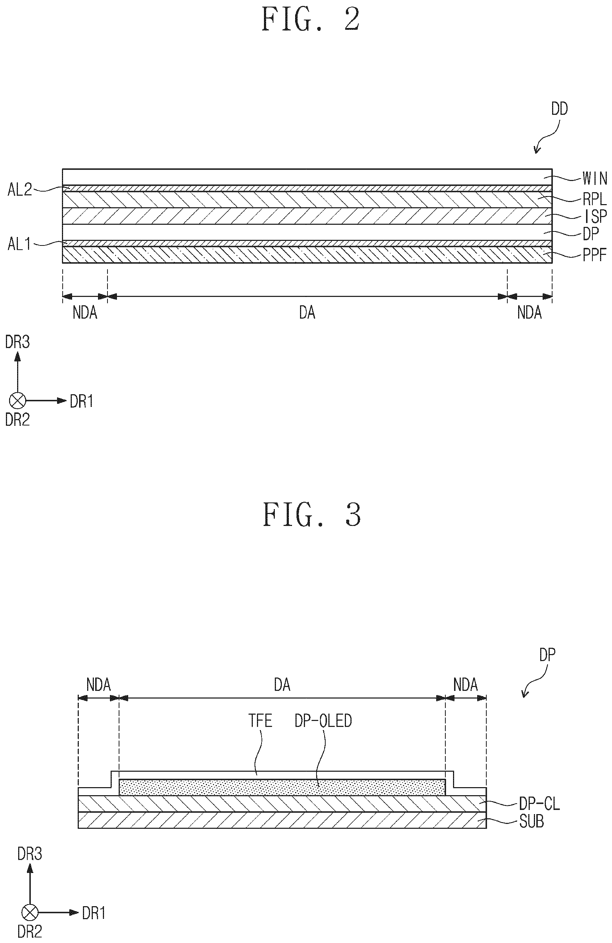

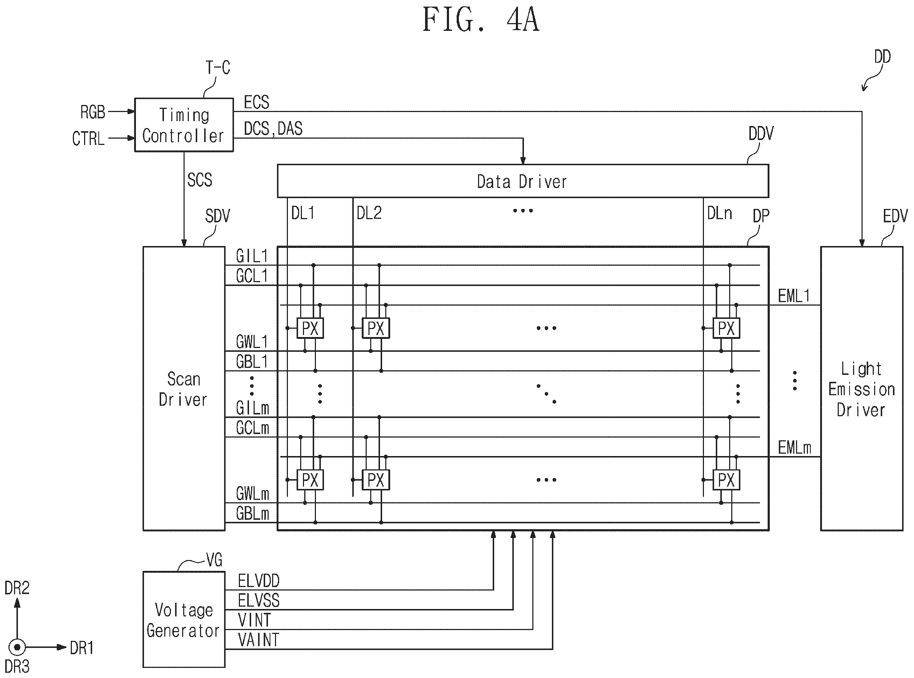

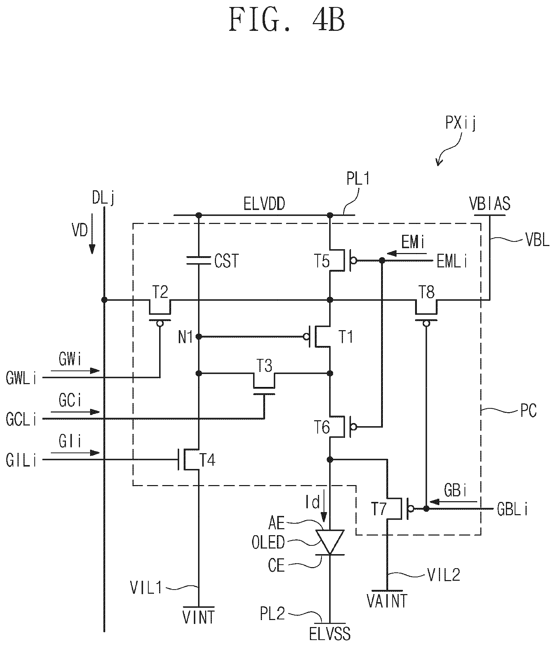

FIG. 1A is a schematic perspective view of an electronic device according to an embodiment of the disclosure. FIG. 1B is a schematic block diagram of an electronic device according to an embodiment of the disclosure. FIG. 2 is a schematic cross-sectional view of an electronic device according to an embodiment of the disclosure. FIG. 3 is a schematic cross-sectional view of a display panel according to an embodiment of the disclosure. FIG. 4A is a schematic block diagram of a display module according to an embodiment of the disclosure. FIG. 4B is a schematic diagram of an equivalent circuit of one of pixels illustrated in FIG. 4A.

Referring to FIG. 1A, an electronic device DD according to an embodiment of the disclosure may have long sides extending in parallel in a first direction DR1, and short sides extending in parallel in a second direction DR2 intersecting the first direction DR1. Corners of the electronic device DD which connect the long sides and the short sides may have a curved shape. The corners of the electronic device DD which have a curved shape may be defined as round corners. The above-described shape of the electronic device DD may be defined as a round-corner quadrangle. However, this is merely an example of the shape of one electronic device DD, and the shape of the electronic device DD is not limited to a round-corner quadrangle.

Hereinafter, a direction substantially perpendicularly intersecting a plane defined by the first direction DR1 and the second direction DR2 is defined as a third direction DR3. The meaning of being viewed on a plane is defined as being viewed in the third direction DR3.

A front surface of the electronic device DD may be defined as a display surface DS, and may have the plane defined by the first direction DR1 and the second direction DR2. Images IM generated in the electronic device DD may be provided to a user through the display surface DS.

The display surface DS may include a display region DA and a non-display region NDA around the display region DA. The display region DA may display an image, and the non-display region NDA may not display an image. The non-display region NDA surrounds the display region DA, and may define the edge of the electronic device DD printed in a predetermined color.

The display region DA may have a round-corner quadrangular shape depending on the shape of the electronic device DD. For example, the display region DA may include sides of a quadrangle which extend in the first direction DR1 and the second direction DR2, and rounded corners which connect the sides. Among four sides, sides extending in the first direction DR1 may be defined as long sides, and among the four sides, sides extending in the second direction DR2 may be defined as short sides.

The electronic device DD may sense inputs applied from the outside of the electronic device DD. For example, the electronic device DD may sense a first input by a touch pen PEN and a second input by a touch TC. The touch pen PEN may be defined as an input device.

The touch pen PEN may be an active pen configured to output a signal. The second input by the touch TC may include various forms of external inputs such as a part of a user's body, light, heat, or pressure.

The electronic device DD and the touch pen PEN may communicate in a bidirectional manner. The electronic device DD may provide an up-link signal to the touch pen PEN. For example, the up-link signal may include information, such as panel information and a protocol version, but embodiments of the disclosure are not particularly limited thereto.

The touch pen PEN may provide a down-link signal to the electronic device DD. The down-link signal may include a synchronization signal or information on the state of the touch pen PEN. For example, the down-link signal may include coordinate information of the touch pen PEN, battery information of the touch pen PEN, slope information of the touch pen PEN, and/or various information stored in the touch pen PEN, but embodiments of the disclosure are not particularly limited thereto.

The electronic device DD may be used for large-sized electronic devices, such as televisions, monitors, or external advertisement boards. The electronic device DD may be used for small-and-medium-sized electronic devices, such as personal computers, laptops, personal digital terminals, car navigation systems, game consoles, smart phones, tablets, or cameras. However, these are merely proposed as exemplary embodiments, and the electronic device DD may be used for other electronic devices as long as it does not depart from the scope of the disclosure.

FIG. 1B illustrates a schematic block diagram of the electronic device DD according to an embodiment of the disclosure. Referring to FIG. 1B, the electronic device DD may output various information through a display module DM in an operating system. In case that a processor 110 executes an application stored in a memory 120, the display module DM provides information on the application to a user through a display panel DP.

The processor 110 may obtain an external input through an input module 130 or a sensor module 161, and execute an application corresponding to the external input. For example, in case that the user selects a camera icon displayed on the display panel DP, the processor 110 may obtain a user input through an input sensor 161-2, and activate a camera module 171. The processor 110 may transmit image data corresponding to a captured image obtained through the camera module 171 to the display module DM. The display module DM may display an image corresponding to the captured image through the display panel DP.

As another example, in case that personal information authentication is executed in the display module DM, a fingerprint sensor 161-1 may obtain input fingerprint information as input data. The processor 110 may compare the input data obtained through the fingerprint sensor 161-1 with authentication data stored in the memory 120, and execute an application according to a comparison result. The display module DM may display information executed according to a logic of the application through the display panel DP.

As another example, in case that a music streaming icon displayed on the display module DM is selected, the processor 110 may obtain a user input through the input sensor 161-2, and activates a music streaming application stored in the memory 120. In case that a music execution command is input in the music streaming application, the processor 110 activates a sound output module 163 to provide sound information corresponding to the music execution command to the user.

In the above, the operation of the electronic device DD has been briefly described above. Hereinafter, a configuration of the electronic device DD will be described in detail. Some of configurations of the electronic device DD to be described later may be integrated and provided as one configuration, or one configuration may be separated and provided in two or more configurations.

Referring to FIG. 1B, the electronic device DD may communicate with an external electronic device 102 via a network (e.g., a short-range wireless communication network or a long-range wireless communication network). The electronic device DD may include the processor 110, the memory 120, the input module 130, the display module DM, a power module 150, an embedded module 160, and an external module 170. At least one of the above-described components may be omitted from the electronic device DD, or one or more other components may be added thereto. Some components of the above-described components (e.g., the sensor module 161, an antenna module 162, or the sound output module 163) may be integrated into another component (e.g., the display module DM).

The processor 110 may execute software to control at least one other component (e.g., a hardware or software component) of the electronic device DD electrically connected to the processor 110, and may perform various data processing or computation. As at least part of the data processing or computation, the processor 110 may store a command or data received from another component (e.g., the input module 130, the sensor module 161, or a communication module 173) in a volatile memory 121, and may process the command or data stored in the volatile memory 121, and result data may be stored in a non-volatile memory 122.

The processor 110 may include a main processor 111 and an auxiliary processor 112. The main processor 111 may include one or more of a central processing unit (CPU) 111-1 or an application processor (AP). The main processor 111 may further include one or more of a graphic processing unit (GPU) 111-2, a communication processor (CP), and an image signal processor (ISP). The main processor 111 may further include a neural processing unit (NPU) 111-3. The neural processing unit 111-3 may be a processor specialized for processing an artificial intelligence model, and the artificial intelligence model may be generated through machine learning. The artificial intelligence model may include multiple artificial neural network layers. An artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-networks, or a combination of two or more thereof, but is not limited to the above-described examples. The artificial intelligence model may additionally or alternatively include a software structure other than a hardware structure. At least two of the above-described processing units and processors may be implemented as one integrated configuration (e.g., a single chip), or each thereof may be implemented as an independent configuration (e.g., multiple chips).

The auxiliary processor 112 may include a controller 112-1. The controller 112-1 may include an interface conversion circuit and a timing control circuit. The controller 112-1 may receive an image signal from the main processor 111, convert a data format of the image signal to meet interface specifications with the display module DM, and output image data. The controller 112-1 may output various control signals necessary for driving the display module DM.

The auxiliary processor 112 may further include a data conversion circuit 112-2, a gamma correction circuit 112-3, a rendering circuit 112-4, and the like. The data conversion circuit 112-2 may receive the image data from the controller 112-1, and may compensate for the image data such that an image may be displayed with a desired luminance according to characteristics of the electronic device DD, settings of a user, or the like, or may convert the image data for power consumption reduction, afterimage correction, or the like. The gamma correction circuit 112-3 may convert the image data, a gamma reference voltage, or the like such that an image displayed on the electronic device DD has desired gamma characteristics. The rendering circuit 112-4 may receive the image data from the controller 112-1, and may render the image data in consideration of a pixel arrangement of the display panel DP applied to the electronic device DD, or the like. At least one of the data conversion circuit 112-2, the gamma correction circuit 112-3, or the rendering circuit 112-4 may be integrated into another component (e.g., the main processor 111 or the controller 112-1). At least one of the data conversion circuit 112-2, the gamma correction circuit 112-3, or the rendering circuit 112-4 may be integrated into a data driver DDV to be described later.

The memory 120 may store various data used by at least one component (e.g., the processor 110 or the sensor module 161) of the electronic device DD, and input data or output data for a command related thereto. The memory 120 may include at least one of the volatile memory 121 or the non-volatile memory 122.

The input module 130 may receive a command or data to be used for a component (e.g., the processor 110, the sensor module 161, or the sound output module 163) of the electronic device DD from the outside (e.g., a user or the external electronic device 102) of the electronic device DD.

The input module 130 may include a first input module 131 to which a command or data is input from the user and a second input module 132 to which a command or data is input from the external electronic device 102. The first input module 131 may include a microphone, a mouse, a keyboard, a key (e.g., a button), or a pen (e.g., a passive pen or an active pen). The second input module 132 may support a specified protocol which may be electrically connected to the external electronic device 102 in a wired or wireless manner. The second input module 132 may include a high definition multimedia interface (HDMI), a universal serial bus (USB) interface, a secure digital (SD) card interface, or an audio interface. The second input module 132 may include a connector which is physically connected with the external electronic device 102, for example, an HDMI compliant connector, a USB connector, an SD card connector, or an audio connector (e.g., a headphone connector).

The display module DM visually may provide information to a user. The display module DM may include the display panel DP, a scan driver SDV, and the data driver DDV. The display module DM may further include a window, a chassis, and a bracket for protecting the display panel DP.

The display panel DP may include a liquid crystal display panel, an organic light emitting display panel, or an inorganic light emitting display panel, and the type of the display panel DP is not particularly limited. The display panel DP may be a rigid type, or a flexible type capable of being rolled or folded. The display module DM may further include a window, a bracket, a heat dissipation member, or the like for supporting the display panel DP.

The scan driver SDV may be mounted as a driving chip on the display panel DP. The scan driver SDV may be integrated into the display panel DP. For example, the scan driver SDV may include an amorphous silicon TFT gate (ASG) driver circuit, a low temperature polycrystalline silicon (LTPS) TFT gate driver circuit, or an oxide semiconductor TFT gate (OSG) driver circuit. The scan driver SDV may receive a control signal from the controller 112-1, and output scan signals to the display panel DP in response to the control signal.

The display panel DP may further include a light emission driver. The light emission driver may output an emission control signal to the display panel DP in response to a control signal received from the controller 112-1. The light emission driver may be formed separately from the scan driver SDV, or may be integrated into the scan driver SDV.

The data driver DDV may receive a control signal from the controller 112-1, convert image data into an analog voltage (e.g., a data voltage) in response to the control signal, and then output data voltages to the display panel DP.

The data driver DDV may be integrated into another component (e.g., the controller 112-1). The function of the interface conversion circuit and the timing control circuit of the controller 112-1 described above may be integrated into the data driver DDV.

The display module DM may further include a light emission driver, a voltage generating circuit, and the like. The voltage generating circuit may output various voltages necessary for driving the display panel DP.

The power module 150 may supply power to a component of the electronic device DD. The power module 150 may include a battery for charging a power voltage. The battery may include a primary cell which is not rechargeable, a secondary cell which is rechargeable, or a fuel cell. The power module 150 may include a power management integrated circuit (PMIC). The PMIC may supply power which is optimized to each of the above-described modules and modules to be described later. The power module 150 may include a wireless power transmission/reception member electrically connected to the battery. The wireless power transmission/reception member may include multiple antenna radiators in the form of a coil.

The electronic device DD may further include the embedded module 160 and the external module 170. The embedded module 160 may include the sensor module 161, the antenna module 162, and the sound output module 163. The external module 170 may include the camera module 171, a light module 172, and the communication module 173.

The sensor module 161 senses an input by a user's body or an input by a pen of the first input module 131, and may generate an electrical signal or a data value corresponding to the input. The sensor module 161 may include one or more of the fingerprint sensor 161-1, the input sensor 161-2, or a digitizer 161-3.

The fingerprint sensor 161-1 may generate a data value corresponding to a fingerprint of a user. The fingerprint sensor 161-1 may include any one of a fingerprint sensor in an optical or capacitive manner.

The input sensor 161-2 may generate a data value corresponding to coordinate information on an input by a user's body or an input by a pen. The input sensor 161-2 generates an amount of change in capacitance by an input as a data value. The input sensor 161-2 may sense an input by a passive pen, or may transmit and receive data to and from an active pen.

The input sensor 161-2 may measure a biometric signal such as blood pressure, moisture, or body fat. For example, if a user touches a sensor layer or sensing panel with a part of the body and does not move for a predetermined period of time, the input sensor 161-2 may sense a biometric signal based on a change in electric field caused by the part of the body, and may output information desired by the user to the display module DM.

The digitizer 161-3 may generate a data value corresponding to coordinate information on an input by a pen. The digitizer 161-3 generates an amount of change in electromagnetism caused by an input as a data value. The digitizer 161-3 may sense an input by a passive pen, or may transmit and receive data to and from an active pen.

At least one of the fingerprint sensor 161-1, the input sensor 161-2, or the digitizer 161-3 may be implemented as a sensor layer formed on the display panel DP through a continuous process. The fingerprint sensor 161-1, the input sensor 161-2, and the digitizer 161-3 may be disposed on an upper side of the display panel DP, and any one of the fingerprint sensor 161-1, the input sensor 161-2, and the digitizer 161-3, for example, the digitizer 161-3, may be disposed on a lower side of the display panel DP.

At least two of the fingerprint sensor 161-1, the input sensor 161-2, and the digitizer 161-3 may be formed to be integrated into one sensing panel through the same process. If integrated with one sensing panel, the sensing panel may be disposed between the display panel DP and a window which is disposed on an upper side of the display panel DP. The sensing panel may be disposed on the window, and the position of the sensing panel is not particularly limited.

At least one of the fingerprint sensor 161-1, the input sensor 161-2, or the digitizer 161-3 may be embedded in the display panel DP. For example, at least one of the fingerprint sensor 161-1, the input sensor 161-2, or the digitizer 161-3 may be simultaneously formed through a process of forming elements (e.g., a light emitting element, a transistor, etc.) included in the display panel DP.

The sensor module 161 may generate an electrical signal or a data value corresponding to an internal state or external state of the electronic device DD. The sensor module 161 may further include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The antenna module 162 may include one or more antennas for transmitting or receiving a signal or power to or from the outside. The communication module 173 may transmit a signal to an external electronic device or receive a signal from an external electronic device through an antenna suitable for a communication method. An antenna pattern of the antenna module 162 may be integrated into one component (e.g., the display panel DP) of the display module DM, the input sensor 161-2, or the like.

The sound output module 163 is a device for outputting sound signals to the outside of the electronic device DD, and may include, for example, a speaker used for general purposes, such as multimedia playback or recording playback, and a receiver used exclusively for receiving phone calls. The receiver may be formed integrally with or separately from the speaker. A sound output pattern of the sound output module 163 may be integrated with the display module DM.

The camera module 171 may capture still images or moving images. The camera module 171 may include one or more lenses, an image sensor, or an image signal processor. The camera module 171 may further include an infrared camera capable of measuring the presence or absence of a user, the user's position, the user's gaze, and the like.

The light module 172 may provide light. The light module 172 may include a light emitting diode or a xenon lamp. The light module 172 may operate in conjunction with the camera module 171 or may operate independently.

The communication module 173 may assist in establishing a wired or wireless communication channel between the electronic device DD and the external electronic device 102, and performing communication via the established communication channel. The communication module 173 may include either or both of a wireless communication module, such as a cellular communication module, a short-range wireless communication module, or a global navigation satellite system (GNSS) communication module, and a wired communication module, such as a local area network (LAN) communication module, or a power line communication module. The communication module 173 may communicate with the external electronic device 102 via a short-range communication network, such as Bluetooth, WiFi direct, or infrared data association (IrDA), or a long-range communication network, such as a cellular network, the Internet, or a computer network (e.g., a LAN or WAN). The above-described various types of the communication modules 173 may be implemented as a single chip or may be implemented as separate chips.

The input module 130, the sensor module 161, the camera module 171, and the like may be used in conjunction with the processor 110 to control the operation of the display module DM.

Based on input data received from the input module 130, the processor 110 may output a command or data to the display module DM, the sound output module 163, the camera module 171, or the light module 172. For example, the processor 110 may generate image data in response to input data applied through a mouse or an active pen and output the image data to the display module DM, or may generate command data corresponding to the input data and output the command data to the camera module 171 or the light module 172. If input data is not received from the input module 130 for a predetermined period of time, the processor 110 may convert an operation mode of the electronic device DD into a low-power mode or a sleep mode to reduce power consumed in the electronic device DD.

Based on sensing data received from the sensor module 161, the processor 110 may output a command or data to the display module DM, the sound output module 163, the camera module 171, or the light module 172. For example, the processor 110 may compare authentication data applied by the fingerprint sensor 161-1 with the authentication data stored in the memory 120, and then may execute an application according to a comparison result. The processor 110 may execute a command based on sensing data sensed by the input sensor 161-2 or the digitizer 161-3, or may output corresponding image data to the display module DM. If the sensor module 161 includes a temperature sensor, the processor 110 may receive temperature data on a measured temperature from the sensor module 161, and may further perform luminance correction and the like on the image data based on the temperature data.

The processor 110 may receive measurement data on the presence or absence of a user, the user's position, the user's gaze, and the like from the camera module 171. The processor 110 may further perform luminance correction and the like on the image data based on the measurement data. For example, the processor 110, which determines the presence or absence of a user through an input from the camera module 171, may output the image data with corrected luminance to the display module DM through the data conversion circuit 112-2 or the gamma correction circuit 112-3.

Some components of the above-described components may be electrically connected to each other through a communication method between peripheral devices, such as a bus, general purpose input/output (GPIO), serial peripheral interface (SPI), mobile industry processor interface (MIPI), or ultra path interconnect (UPI) link and exchange signals (e.g., a command or data) with each other. The processor 110 may communicate with the display module DM in a mutually agreed interface, and for example, may use any one of the above-described communication methods, and is not limited to the above-described communication methods.

The electronic device DD according to various embodiments disposed herein may be a device of various forms. The electronic device DD may include, for example, at least one of a portable communication device (e.g., a smart phone), a computer device, a portable multimedia device, a portable medical device, a camera, a wearable device, or a home appliance. The electronic device DD according to embodiments of the disclosure is not limited to the above-described devices.

FIG. 2 is a schematic view illustrating a cross-section of the electronic device illustrated in FIG. 1A. FIG. 2 illustrates a schematic cross-sectional of the electronic device DD viewed in the second direction DR2. FIG. 2 illustrates the electronic device DD in which some of the components thereof described with reference to FIG. 1B are omitted.

Referring to FIG. 2, the electronic device DD may include the display panel DP, an input sensor ISP, a reflection prevention layer RPL, a window WIN, a panel protection film PPF, and first and second adhesive layers AL1 and AL2. The input sensor ISP illustrated in FIG. 2 may have the same configuration as the input sensor 161-2 described with reference to FIG. 1B.

The display panel DP according to an embodiment of the disclosure may be a light emitting-type display panel. For example, the display panel DP may be an organic light emitting display panel or inorganic light emitting display panel. A light emitting layer of the organic light emitting display panel may include an organic light emitting material. A light emitting layer of the inorganic light emitting display panel may include a quantum dot, a quantum rod, and the like. Hereinafter, the display panel DP will be described as an organic light emitting display panel.

The input sensor ISP may be disposed on the display panel DP. The input sensor ISP may include multiple sensing units (not shown) for sensing an external input in a capacitive manner. The input sensor ISP may be manufactured (or directly manufactured) on the display panel DP when manufacturing the electronic device DD. Therefore, the input sensor ISP according to an embodiment may be disposed (or directly disposed) on the display panel DP. However, embodiments of the disclosure are not limited thereto, and the input sensor ISP may be manufactured as a separate panel from the display panel DP, and may be attached to the display panel DP by an adhesive layer.

The reflection prevention layer RPL may be disposed on the input sensor ISP. The reflection prevention layer RPL may be manufactured directly on the input sensor ISP when manufacturing the electronic device DD. However, embodiments of the disclosure are not limited thereto, and the reflection prevention layer RPL may be manufactured as a separate panel, and may be attached to the input sensor ISP by an adhesive layer.

The reflection prevention layer RPL may be defined as an external light reflection prevention film. The reflection prevention layer RPL may reduce the reflectance of external light incident from the above of the electronic device DD toward the display panel DP. The external light may not be visibly recognized by a user due to the reflection prevention layer RPL.

In case that the external light incident toward the display panel DP reflects from the display panel DP and is provided again to an external user, like a mirror, the user may visually recognize the external light. In order to prevent the above-described phenomenon, illustratively, the reflection prevention layer RPL may include multiple color filters for displaying the same color as pixels of the display panel DP.

The color filters may filter the external light to the same color as the pixels. For example, the external light may not be visually recognized by a user. However, embodiments of the disclosure are not limited thereto, and the reflection prevention layer RPL may include a phase retarder and/or a polarizer in order to reduce the reflectance of the external light.

The window WIN may be disposed on the reflection prevention layer RPL. The window WIN may protect the display panel DP, the input sensor ISP, and the reflection prevention layer RPL from external scratches and impacts (or forces).

The panel protection film PPF may be disposed below the display panel DP. The panel protection film PPF may protect a lower portion of the display panel DP. The panel protection film PPF may include a flexible plastic material such as polyethyleneterephthalate (PET).

The first adhesive layer AL1 may be disposed between the display panel DP and the panel protection film PPF, and by the first adhesive layer AL1, the display panel DP and the panel protection film PPF may be bonded to each other. The second adhesive layer AL2 may be disposed between the window WIN and the reflection prevention layer RPL, and by the second adhesive layer AL2, the window WIN and the reflection prevention layer RPL may be bonded to each other.

FIG. 3 is a schematic view illustrating a cross-sectional of the display panel illustrated in FIG. 2. Illustratively, FIG. 3 illustrates a schematic cross-sectional of the display panel DP viewed in the second direction DR2.

Referring to FIG. 3, the display panel DP may include a substrate SUB, a circuit element layer DP-CL disposed on the substrate SUB, a display element layer DP-OLED disposed on the circuit element layer DP-CL, and a thin film encapsulation layer TFE disposed on the display element layer DP-OLED.

The substrate SUB may include a display region DA and a non-display region NDA around the display region DA. The substrate SUB may include glass or may include a flexible plastic material such as glass or polyimide (PI). The display element layer DP-OLED may be disposed in the display region DA.

Multiple pixels may be disposed on the circuit element layer DP-CL and the display element layer DP-OLED. Each of the pixels may include a transistor disposed in the circuit element layer DP-CL and a light emitting element disposed in the display element layer DP-OLED and electrically connected to the transistor.

The thin film encapsulation layer TFE may be disposed on the circuit element layer DP-CL to cover the display element layer DP-OLED. The thin film encapsulation layer TFE may protect the pixels from moisture, oxygen, and a foreign substance. The thin film encapsulation layer TFE may include inorganic layers and an organic layer. The organic layer may be disposed between the inorganic layers and sealed by the inorganic layers to provide a flat surface. The organic layer may be disposed on the inorganic layers or may be omitted, and is not limited to any one embodiment.

FIG. 4A is a schematic block diagram of the electronic device illustrated in FIG. 1A.

Referring to FIG. 4A, the electronic device DD may include the display panel DP, a timing controller T-C, a scan driver SDV, a data driver DDV, a light emission driver EDV, and a voltage generator VG.

The display panel DP may include multiple scan lines GIL1 to GILm, GCL1 to GCLm, GWL1 to GWLm, and GBL1 to GBLm, multiple light emission control lines EML1 to EMLm, multiple data lines DL1 to DLn, and multiple pixels PX (m and n are natural numbers greater than 0).

The pixels PX may be electrically connected to the scan lines GIL1 to GILm, GCL1 to GCLm, GWL1 to GWLm, and GBL1 to GBLm, the light emission control lines EML1 to EMLm, and the data lines DL1 to DLn, respectively. Each of the pixels PX may be electrically connected to four corresponding scan lines, one corresponding data line, and one corresponding light emission control line.

The scan lines GIL1 to GILm, GCL1 to GCLm, GWL1 to GWLm, and GBL1 to GBLm may include multiple scan lines GIL1 to GILm which are initialization scan lines (also referred to as initialization scan lines GIL1 to GILm), multiple scan lines GCL1 to GCLm which are compensation scan lines (also referred to as compensation scan lines GCL1 to GCLm), multiple scan lines GWL1 to GWLm which are write scan lines (also referred to as write scan lines GWL1 to GWLm), and multiple scan lines GBL1 to GBLm which are bias scan lines (also referred to as bias scan lines GBL1 to GBLm).

Each of the pixels PX may be electrically connected to a corresponding one among the initialization scan lines GIL1 to GILm, a corresponding one among the compensation scan lines GCL1 to GCLm, a corresponding one of the write scan lines GWL1 to GWLm, and a corresponding one among the bias scan lines GBL1 to GBLm.

The scan lines GIL1 to GILm, GCL1 to GCLm, GWL1 to GWLm, and GBL1 to GBLm may be electrically connected to the scan driver SDV, and may be extended in the first direction DR1 to be arranged in the second direction DR2. The light emission control lines EML1 to EMLm may be electrically connected to the light emission driver EDV, and may be extended in the first direction DR1 to be arranged in the second direction DR2. The data lines DL1 to DLn may be electrically connected to the data driver DDV, and may be extended in the second direction DR2 to be arranged in the first direction DR1.

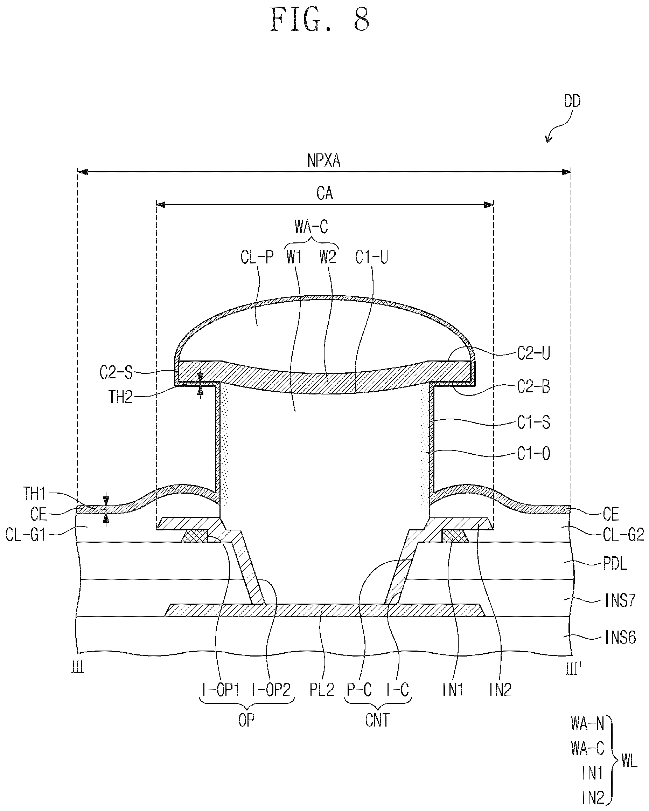

The scan driver SDV, the light emission driver EDV, and the data driver DDV may substantially be disposed on the display panel DP, and such a configuration will be described below with reference to FIG. 8.

The timing controller T-C may receive an image signal RGB and a control signal CTRL. The timing controller T-C may generate an image data signal DAS obtained by converting a data format of the image signal RGB to meet interface specifications with the data driver DDV. The timing controller T-C may output a scan control signal SCS, a data control signal DCS, and a light emission control signal ECS in response to the control signal CTRL.

The voltage generator VG may generate voltages necessary for the operation of the display panel DP. The voltage generator VG may generate a first driving voltage ELVDD, a second driving voltage ELVSS, a first initialization voltage VINT, and a second initialization voltage VAINT. The first driving voltage ELVDD, the second driving voltage ELVSS, the first initialization voltage VINT, and the second initialization voltage VAINT may be applied to the pixels PX.

The scan driver SDV may receive the scan control signal SCS from the timing controller T-C. The scan driver SDV may output scan signals to the scan lines GIL1 to GILm, GCL1 to GCLm, GWL1 to GWLm, and GBL1 to GBLm in response to the scan control signal SCS. The scan signals may be applied to the pixels PX through the scan lines GIL1 to GILm, GCL1 to GCLm, GWL1 to GWLm, and GBL1 to GBLm.

The data driver DDV may receive the data control signal DCS and the image data signal DAS from the timing controller T-C. The data driver DDV may convert the image data signal DAS into data signals and output the data signals. The data signals may be defined as analog voltages corresponding to a gray level of the image data signal DAS. The data signals may be applied to the pixels PX through the data lines DL1 to DLn.

The light emission driver EDV may receive the light emission control signal ECS from the timing controller T-C. In response to the light emission control signal ECS, the light emission driver EDV may output light emission signals to the light emission control lines EML1 to EMLm. The light emission signals may be applied to the pixels PX through the light emission control lines EML1 to EMLm.

The pixels PX may be provided with the data voltages in response to the scan signals. The pixels PX may display an image by emitting light of luminance corresponding to the data voltages in response to the light emission signals.

FIG. 4B is a schematic diagram of an equivalent circuit of one of pixels illustrated in FIG. 4A.

Illustratively, FIG. 4B illustrates a pixel PXij electrically connected to a j-th data line DLj, i-th scan lines GWLi, GCLi, GILi, and GBLi, and an i-th light emission control line EMLi. i and j are natural numbers greater than 0.

Referring to FIG. 4B, the pixel PXij may include a pixel circuit PC and a light emitting element OLED electrically connected to the pixel circuit PC. The pixel circuit PC may drive the light emitting element OLED.

The pixel circuit PC may include multiple transistors T1 to T8 and a capacitor CST. The transistors T1 to T8 and the capacitor CST may control the amount of current flowing through the light emitting element OLED. The light emitting element OLED may generate light having a predetermined luminance according to the amount of current received.

An i-th write scan line GWLi may receive an i-th write scan signal GWi, and an i-th compensation scan line GCLi may receive an i-th compensation scan signal GCi. An i-th initialization scan line GILi may receive an i-th initialization scan signal GIi, and an i-th bias scan line GBLi may receive an i-th bias scan signal GBi. The i-th light emission control line EMLi may receive an i-th light emission signal EMi.

The pixel PXij may be electrically connected to the j-th data line DLj, the i-th write scan line GWLi, the i-th compensation scan line GCLi, the i-th initialization scan line GILi, the i-th bias scan line GBLi, the i-th light emission control line EMLi, a first initialization line VIL1, a second initialization line VIL2, a bias line VBL, and first and second power lines PL1 and PL2.

The first initialization line VIL1 may receive the first initialization voltage VINT, and the second initialization line VIL2 may receive the second initialization voltage VAINT. The bias line VBL may receive a bias voltage VBIAS. The first power line PL1 may receive the first driving voltage ELVDD, and the second power line PL2 may receive the second driving voltage ELVSS.

Each of the transistors T1 to T8 may include a source electrode, a drain electrode, and a gate electrode. Hereinafter, in FIG. 4B, one of the source electrode and the drain electrode is defined as a first electrode, and the other thereof is defined as a second electrode for convenience. The gate electrode is defined as a control electrode.

The transistors T1 to T8 may include first to eighth transistors T1 to T8. The first, second, and fifth to eighth transistors T1 ,T2, and T5 to T8 may be PMOS transistors. The third and fourth transistors T3 and T4 may be NMOS transistors.

The first transistor T1 may be defined as a driving transistor, and the second transistor T2 may be defined as a switching transistor. The third transistor T3 may be defined as a compensation transistor. The fourth transistor T4 and the seventh transistor T7 may be defined as initialization transistors. The fifth transistor T5 and the sixth transistor T6 may be defined as light emission control transistors. The eighth transistor T8 may be defined as a bias transistor.

The light emitting element OLED may be defined as an organic light emitting element. The light emitting element OLED may include a first electrode AE and a second electrode CE. The first electrode AE may receive the first driving voltage ELVDD through the sixth, first, and fifth transistors T6, T1, and T5. The first driving voltage ELVDD may be applied to the pixel circuit PC through the first power line PL1.

The second electrode CE may receive the second driving voltage ELVSS having a lower level than the first driving voltage ELVDD. The second driving voltage ELVSS may be applied to the pixel circuit PC through the second power line PL2.

The first transistor T1 may be disposed between the fifth transistor T5 and the sixth transistor T6, and may be connected to the fifth transistor T5 and the sixth transistor T6. The first transistor T1 may be connected to the first power line PL1 through the fifth transistor T5, and may be connected to the first electrode AE through the sixth transistor T6.

The first transistor T1 may include a first electrode connected to the first power line PL1 through the fifth transistor T5, a second electrode connected to the first electrode AE through the sixth transistor T6, and a control electrode connected to a first node N1.

The first electrode of the first transistor T1 may be connected to the fifth transistor T5, and the second electrode of the first transistor T1 may be connected to the sixth transistor T6. The first transistor T1 may control the amount of current flowing through the light emitting element OLED according to a voltage of the first node N1 applied to the control electrode of the first transistor T1.

The second transistor T2 may be disposed between the first transistor T1 and the j-th data line DLj and may be connected to the first transistor T1 and the j-th data line DLj. The second transistor T2 may include a first electrode connected to the j-th data line DLj, a second electrode connected to the first electrode of the first transistor T1, and a control electrode connected to the i-th write scan line GWLi.

The second transistor T2 may be turned on by the i-th write scan signal GWi received through the i-th write scan line GWLi and electrically connect the j-th data line DLj and the first electrode of the first transistor T1. The second transistor T2 may perform a switching operation of providing a data voltage VD (corresponding to the data signal described above) received through the j-th data line DLj to the first electrode of the first transistor T1.

The third transistor T3 may be connected to the second electrode of the first transistor T1 and to the first node N1. The third transistor T3 may include a first electrode connected to the second electrode of the first transistor T1, a second electrode connected to the first node N1, and a control electrode connected to the i-th compensation scan line GCLi.

The third transistor T3 may be turned on by the i-th compensation scan signal GCi received through the i-th compensation scan line GCLi and electrically connect the second electrode of the first transistor T1 and the control electrode of the first transistor T1. In case that the third transistor T3 is turned on, the first transistor T1 and the third transistor T3 may be connected in a diode form.

The fourth transistor T4 may be connected to the first node N1. The fourth transistor T4 may include a first electrode connected to the first node N1, a second electrode connected to the first initialization line VIL1, and a control electrode connected to the j-th initialization scan line GILi. The fourth transistor T4 may be turned on by the i-th initialization scan signal GIi through the j-th initialization scan line v and provide the first initialization voltage VINT received through the first initialization line VIL1 to the first node ND.

The fifth transistor T5 may include a first electrode connected to the first power line PL1, a second electrode connected to the first electrode of the first transistor T1, and a control electrode connected to the i-th light emission control line EMLi.

The sixth transistor T6 may include a first electrode connected to the second electrode of the first transistor T1, a second electrode connected to the first electrode AE, and a control electrode connected to the i-th light emission control line EMLi.

The fifth transistor T5 and the sixth transistor T6 may be turned on by the i-th light emission signal EMi received through the i-th light emission control line EMLi. The first driving voltage ELVDD may be provided to the light emitting element OLED by the fifth transistor T5 and the sixth transistor T6 which are turned on, so that a driving current may flow through the light emitting element OLED. As a result, the light emitting element OLED may emit light.

The seventh transistor T7 may include a first electrode connected to the first electrode AE, a second electrode connected to the second initialization line VIL2, and a control electrode connected to the i-th bias scan line GBLi. The seventh transistor T7 may be turned on by the i-th bias scan signal GBi received through the i-th bias scan line GBLi, and may provide the second initialization voltage VAINT received through the second initialization line VIL2 to the first electrode AE of the light emitting element OLED.

The second initialization voltage VAINT may have a different level from the first initialization voltage VINT, but is not limited thereto, and may have the same level as the first initialization voltage VINT.

The seventh transistor T7 may improve the capability of the pixel PXij to express black. In case that the seventh transistor T7 is turned on, a parasitic capacitor (not shown) of the light emitting element OLED may be discharged. Therefore, in case that black luminance is implemented, the light emitting element OLED does not emit light due to a leakage current from the first transistor T1, and accordingly, the black expression capability may be improved.

The capacitor CST may include a first electrode connected to the first power line PL1 and a second electrode connected to the first node N1. In case that the fifth transistor T5 and the sixth transistor T6 are turned on, the amount of current flowing through the first transistor T1 may be determined according to a voltage stored in the capacitor CST.

The eighth transistor T8 may include a first electrode connected to the bias line VBL, a second electrode connected to the first electrode of the first transistor T1, and a control electrode connected to the i-th bias scan line GBLi.

The eighth transistor T8 may be turned on by the i-th bias scan signal GBi received through the i-th bias scan line GBLi, and may provide the bias voltage VBIAS received through the bias line VBL to the first electrode of the first transistor T1. However, the transistors included in the pixel PXij are not limited thereto.

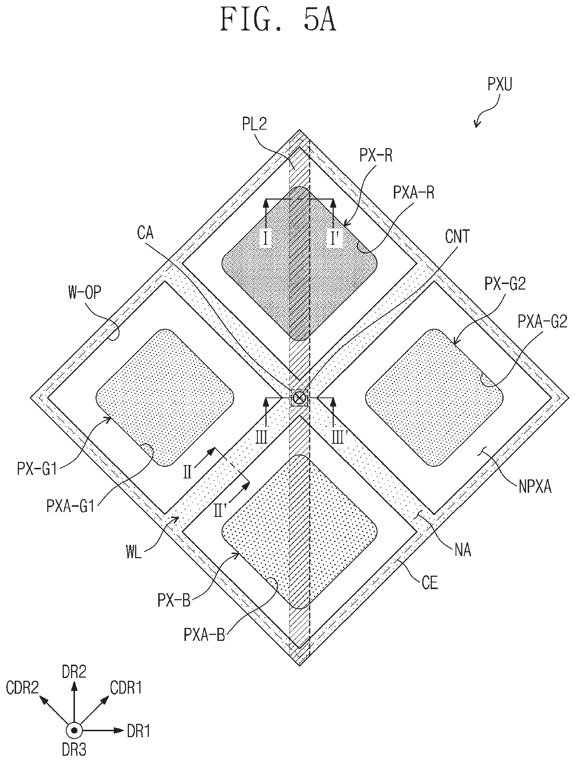

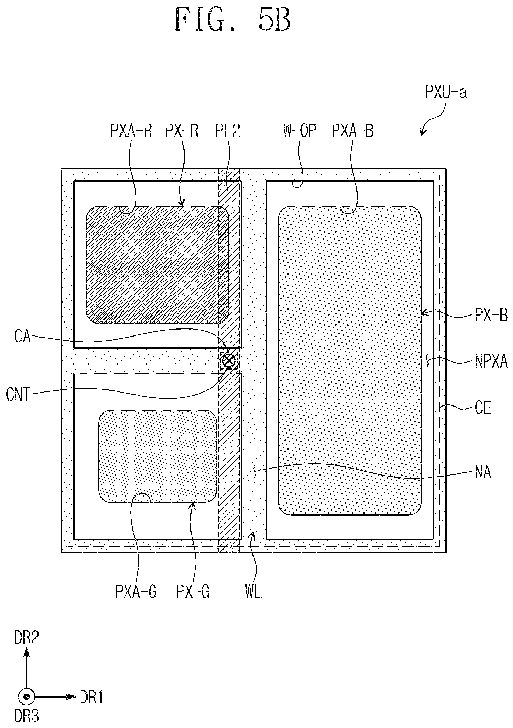

FIG. 5A is a schematic plan view of a pixel unit according to an embodiment of the disclosure. FIG. 5B is a schematic plan view of a pixel unit according to an embodiment of the disclosure.

Referring to FIG. 5A, one pixel unit PXU may include the pixels PXij described with reference to FIGS. 4A and 4B. The pixel unit PXU may be provided in plurality and may be arranged along first and second diagonal directions CDR1 and CDR2 in the display region DA described with reference to FIG. 1A.

The pixel unit PXU according to an embodiment may include first-first, first-second, second, and third pixels PX-G1, PX-G2, PX-R, and PX-B. The first-first pixel PX-G1 may provide green light. Light generated in the first- first pixel PX-G1 may be provided to the display region DA (see FIG. 1A) through a first-first light emitting region PXA-G1. The first-first light emitting region PXA-G1 may have a rhombic shape.

The first-second pixel PX-G2 may provide green light like the first-first pixel PX-G1. Light generated in the first-second pixel PX-G2 may be provided to the display region DA (see FIG. 1A) through a first-second light emitting region PXA-G2. The first-second light emitting region PXA-G2 may be spaced apart from the first-first light emitting region PXA-G1 along the first direction DR1. The first-second light emitting region PXA-G2 may have a rhombic shape.

The second pixel PX-R may provide red light. Light generated in the second pixel PX-R may be provided to the display region DA (see FIG. 1A) through a second light emitting region PXA-R. The second light emitting region PXA-R may be spaced apart from a third light emitting region PXA-B along the second direction DR2. The second light emitting region PXA-R may be spaced apart from the first-first light emitting region PXA-G1 along a first diagonal direction CDR1, and may be spaced apart from the first-second light emitting region PXA-G2 along a second diagonal direction CDR2. The second light emitting region PXA-R may have a rhombic shape.

The third pixel PX-B may provide blue light. Light generated in the third pixel PX-B may be provided to the display region DA (see FIG. 1A) through the third light emitting region PXA-B. The third light emitting region PXA-B may be spaced apart from the first-second light emitting region PXA-G2 along the second diagonal direction CDR2, and may be spaced apart from the first-first light emitting region PXA-G1 along the first diagonal direction CDR1. The third light emitting region PXA-B may have a rhombic shape.

The area of the second light emitting region PXA-R may be larger than the area of the first-first and first-second light emitting regions PXA-G1 and PXA-G2, and may be smaller than the area of the third light emitting region PXA-B.

A region between the first-first to third light emitting regions PXA-G1, PXA-G2, PXA-R, and PXA-B may be defined as a non-light emitting region NPXA.

The electronic device DD according to the disclosure may include a partition wall WL included in the display panel DP (see FIG. 3). The partition wall WL may be disposed in the non-light emitting region NPXA and may have partition wall openings W-OP overlapping the first-first to third light emitting regions PXA-G1, PXA-G2, PXA-R, and PXA-B. Each of the partition wall openings W-OP may have a rhombic shape. The partition wall openings W-OP may be defined by side surfaces of partition wall patterns included in the partition wall WL and including a metal. A description thereof will be followed. The partition wall WL may surround the pixels PX-G1, PX-G2, PX-R, and PX-B.

FIG. 5A illustrates a portion of the second power line PL2 disposed in the display region DA (see FIG. 1A). The second power line PL2 may cross the pixel unit PXU. FIG. 5A illustrates one second power line PL2 extended in the second direction DR2, but is not limited thereto, and the second power line PL2 may be provided in plurality, and at least one second power line PL2 may be extended along the first direction DR1.

The partition wall WL according to an embodiment may include a normal region NA and a contact region CA in one pixel unit PXU. The contact region CA may be defined as a portion in which the second power line PL2 and a partition wall pattern included in the partition wall WL are in contact with each other through a contact-hole CNT. The normal region NA may correspond to the remaining region except for the contact region CA. FIG. 5A illustrates one contact region CA, but the number of the contact region CA is not limited thereto, and if the second power line PL2 is provided in plurality, the contact region CA may be provided in plurality in one pixel unit PXU.

In FIG. 5A, the second electrode CE included in a light emitting element included in each of the pixels PX-G1, PX-G2, PX-R, and PX-B is illustrated with a dotted line. The second electrode CE may be commonly disposed in the pixels PX-G1, PX-G2, PX-R, and PX-B to have one pattern shape. The second electrode CE may be electrically connected to the second power line PL2 through the partition wall WL including a metal, and a description thereof will be omitted.

Referring to FIG. 5B, one pixel unit PXU-a may include the pixels PXij described with reference to FIGS. 4A and 4B. The pixel unit PXU-a may be provided in plurality and may be arranged along the first and second directions DR1 and DR2 in the display region DA described with reference to FIG. 1A.

The pixel unit PXU-a according to an embodiment may include first to third pixels PX-R, PX-B, and PX-G. The first pixel PX-R may provide red light. Light generated in the first pixel PX-R may be provided to the display region DA (see FIG. 1A) through a first light emitting region PXA-R. The first light emitting region PXA-R may have a round-corner quadrangular shape.

The second pixel PX-B may provide blue light. Light generated in the second pixel PX-B may be provided to the display region DA (see FIG. 1A) through a second light emitting region PXA-B. The second light emitting region PXA-B may be spaced apart from the first light emitting region PXA-R along the first direction DR1. When viewed in the first direction DR1, the second light emitting region PXA-B may overlap the first and third light emitting regions PXA-R and PXA-G. The second light emitting region PXA-B may have a round-corner quadrangular shape extended along the second direction DR2.

The third pixel PX-G may provide green light. Light generated in the third pixel PX-G may be provided to the display region DA (see FIG. 1A) through the third light emitting region PXA-G. The third light emitting region PXA-G may be spaced apart from the first light emitting region PXA-R along the second direction DR2. The third light emitting region PXA-G may have a round-corner quadrangular shape.

The area of the first light emitting region PXA-R may be larger than the area of the third light emitting region PXA-G, and may be smaller than the area of the second light emitting region PXA-B.

A region between the first to third light emitting regions PXA-R, PXA-G, and PXA-B may be defined as a non-light emitting region NPXA.

The electronic device DD according to the disclosure may include a partition wall WL included in the display panel DP (see FIG. 3). The partition wall WL may be disposed in the non-light emitting region NPXA and may have partition wall openings W-OP overlapping the first to third light emitting regions PXA-R, PXA-B, and PXA-G. Each of the partition wall openings W-OP may have a quadrangular shape. The partition wall openings WOP may be defined by side surfaces of partition wall patterns included in the partition wall WL and including a metal. A description thereof will be followed. The partition wall WL may surround the pixels PX-G, PX-R, and PX-B.

FIG. 5B illustrates a portion of the second power line PL2 disposed in the display region DA (see FIG. 1A). The second power line PL2 may cross the pixel unit PXU-a. FIG. 5B illustrates one second power line PL2 extended in the second direction DR2, but is not limited thereto, and the second power line PL2 may be provided in plurality, and at least one second power line PL2 may be extended along the first direction DR1.

The partition wall WL according to an embodiment may include a normal region NA and a contact region CA in one pixel unit PXU-a. The contact region CA may be defined as a portion in which the second power line PL2 and a partition wall pattern included in the partition wall WL are in contact with each other through the contact-hole CNT. The normal region NA may correspond to the remaining region except for the contact region CA.

In FIG. 5B, the second electrode CE included in a light emitting element included in each of the pixels PX-G, PX-R, and PX-B is illustrated with a dotted line. The second electrode CE may be commonly disposed in the pixels PX-G, PX-R, and PX-B to have one pattern shape. The second electrode CE may be electrically connected to the second power line PL2 through the partition wall WL including a metal, and a description thereof will be omitted.

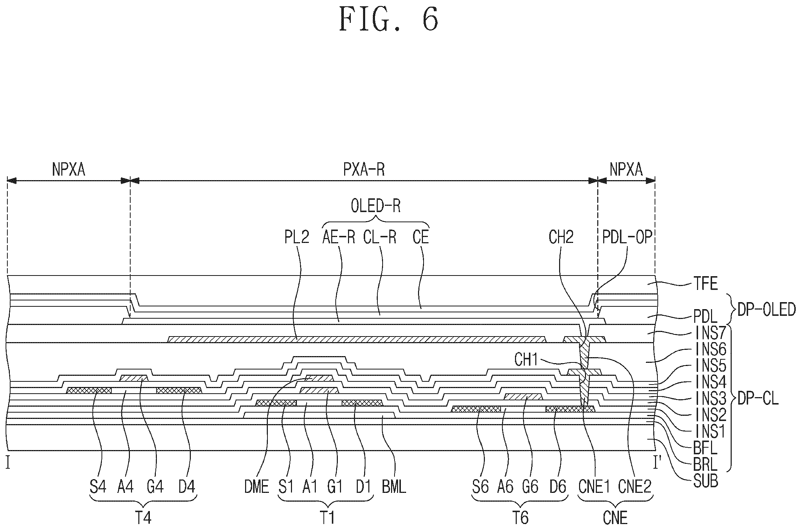

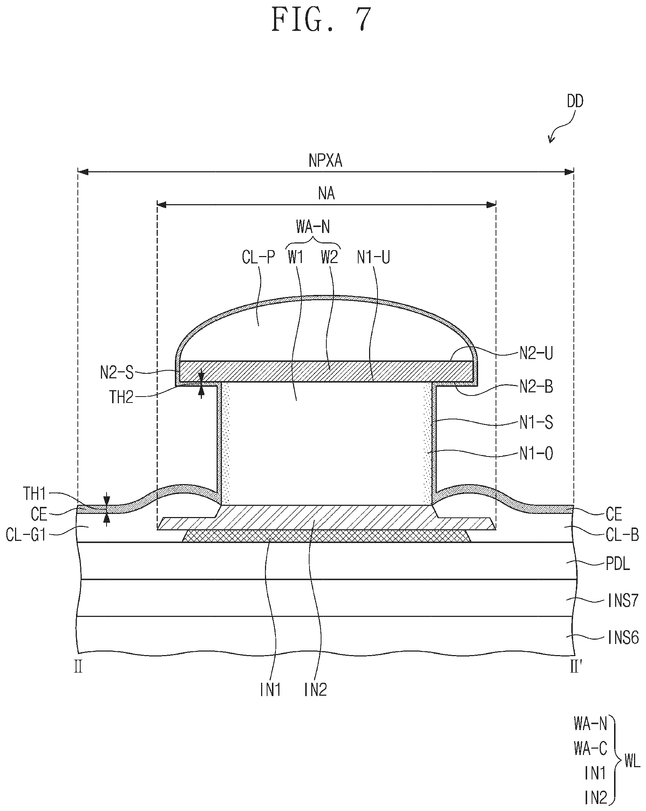

FIG. 6 is a schematic cross-sectional view taken along line I-I' of FIG. 5A. FIG. 7 is a schematic cross-sectional view taken along line II-II' of FIG. 5A. FIG. 8 is a schematic cross-sectional view taken along line III-III' of FIG. 5A.

FIG. 6 illustrates a schematic cross-sectional view of the second pixel PX-R in FIG. 5A. Referring to FIG. 6, the light emitting element OLED-R according to an embodiment may include a first electrode AE-R, a second electrode CE, and a first common layer CL-R. The first common layer CL-R may include a hole control layer, an electron control layer, and a light emitting layer.

The second electrode CE may be disposed on the first electrode AE-R, and the first common layer CL-R may be disposed between the first electrode AE-R and the second electrode CE. The light emitting element OLED-R according to an embodiment may further include a protective layer disposed on the second electrode CE. The protective layer may include an organic material, and may prevent damage to components disposed in a lower portion of the protective layer in a subsequent process. The protective layer may be omitted.

The first, fourth, and sixth transistors T1, T4, and T6 and the light emitting element OLED-R may be disposed on the substrate SUB. The display region DA may include a second light emitting region PXA-R corresponding to the pixel PXij (see FIG. 4B) and a non-light emitting region NPXA adjacent to the second light emitting region PXA-R.

The substrate SUB may include glass or may include a flexible plastic material such as glass or polyimide (PI). The circuit element layer DP-CL, the display element layer DP-OLED, and the thin film encapsulation layer TFE may be sequentially disposed on the substrate SUB. The circuit element layer DP-CL may be disposed on the substrate SUB. The circuit element layer DP-CL may include insulating layers and conductive patterns. The display element layer DP-OLED may include the light emitting element OLED-R and a pixel defining layer PDL.

A barrier layer BRL may be disposed on the substrate SUB. The barrier layer BRL may increase coupling force between a semiconductor pattern included in transistors and the substrate SUB. The barrier layer BRL may include an inorganic material.

A metal layer BML may be disposed on the barrier layer BRL. The metal layer BML may overlap the first transistor T1. The metal layer BML may receive a constant voltage. In case that the constant voltage is applied to the metal layer BML, a threshold voltage Vth value of the first transistor T1 disposed on the metal layer BML may be maintained without being changed.

The metal layer BML may block light incident on the first transistor T1 from a lower portion of the metal layer BML. The metal layer BML may include a reflective metal. The metal layer BML may be omitted.

A buffer layer BFL may be disposed on the barrier layer BRL and may cover the metal layer BML. The buffer layer BFL may include an inorganic material.

Semiconductor layers S1, A1, and D1 of the first transistor T1 and semiconductor layers S6, A6, and D6 of the sixth transistor T6 may be disposed on the buffer layer BFL. The semiconductor layers S1, A1, D1, S6, A6, and D6 may include polysilicon. However, embodiments of the disclosure are not limited thereto, and the semiconductor layers S1, A1, D1, S6, A6, and D6 may include amorphous silicon.

The semiconductor layers S1, A1, D1, S6, A6, and D6 may be doped with an N-type dopant or a P-type dopant. The semiconductor layers S1, A1, D1, S6, A6, and D6 may include a high doping region and a low doping region. The conductivity of the high doping region may be greater than that of the low doping region, and may substantially serve as a source electrode and a drain electrode of the first and sixth transistors T1 and T6. The low doping region may substantially correspond to an active (or a channel) of the first and sixth transistors T1 and T6.

A first source region S1, a first channel region A1, and a first drain region D1 of the first transistor T1 may be formed from the semiconductor layers S1, A1, and D1. A sixth source region S6, a sixth channel region A6, and a sixth drain region D6 of the sixth transistor T6 may be formed from the semiconductor layers S6, A6, and D6. The first channel region A1 may be disposed between the first source region S1 and the first drain region D1. The sixth channel region A6 may be disposed between the sixth source region S6 and the sixth drain region D6.

A first insulating layer INS1 may be disposed on the buffer layer BFL to cover the semiconductor layers S1, A1, D1, S6, A6, and D6. A first gate electrode G1 (or a control electrode) of the first transistor T1 and a sixth gate electrode G6 (or a control electrode) of the sixth transistor T6 may be disposed on the first insulating layer INS1. In a plan view, the first gate electrode G1 may overlap the first channel region A1, and the sixth gate electrode G6 may overlap the sixth channel region A6.

Although not illustrated, structures of a source region, a channel region, a drain region, and a gate electrode of each of the second, fifth, and seventh transistors T2, T5, and T7 may be substantially the same as those of the first and sixth transistors T1 and T6.

A second insulating layer INS2 may be disposed on the first insulating layer INS1 to cover the first and sixth gate electrodes G1 and G6. A dummy electrode DME may be disposed on the second insulating layer INS2. The dummy electrode DME may be disposed on the first gate electrode G1, and in a plan view, may overlap the first gate electrode G1. The dummy electrode DME and the first gate electrode G1 may form the above-described capacitor CST (see FIG. 4B) together.

A third insulating layer INS3 may be disposed on the second insulating layer INS2 to cover the dummy electrode DME. Semiconductor layers S4, A4, and D4 of the fourth transistor T4 may be disposed on the third insulating layer INS3. The semiconductor layers S4, A4, and D4 may include an oxide semiconductor formed of a metal oxide. The oxide semiconductor may include a crystalline or amorphous oxide semiconductor.

The semiconductor layers S4, A4, and D4 may include multiple regions divided according to whether the metal oxide is reduced or not. A region in which the metal oxide is reduced (hereinafter, a reduction region) may have higher conductivity than a region in which the metal oxide is not reduced (hereinafter, a non-reduction region). The reduction region may substantially serve as a source electrode or a drain electrode of the fourth transistor T4. The non-reduction region may substantially correspond to an active (or a channel) of the fourth transistor T4.

A fourth source region S4, a fourth channel region A4, and a fourth drain region D4 of the fourth transistor T4 may be formed from the semiconductor layers S4, A4, and D4. The fourth channel region A4 may be disposed between the fourth source region S4 and the fourth drain region D4.

A fourth insulating layer INS4 may be disposed on the third insulating layer INS3 to cover the semiconductor layers S4, A4, and D4. A fourth gate electrode G4 of the fourth transistor T4 may be disposed on the fourth insulating layer INS4. In a plan view, the fourth gate electrode G5 may overlap the fourth channel region A4.

A fifth insulating layer INS5 may be disposed on the fourth insulating layer INS4 to cover the fourth gate electrode G4. Although not illustrated, structures of a source region, a channel region, a drain region, and a gate electrode of the third transistor T3 may be substantially the same as those of the fourth transistor T4.

The barrier layer BRL, the buffer layer BFL, and the first to fifth insulating layers INS1 to INS5 may include an inorganic material. Illustratively, the barrier layer BRL, the buffer layer BFL, and the first to fifth insulating layers INS1 to INS5 may include any one of silicon oxide and silicon nitride, or one insulating layer may include multi-layered inorganic layers, but embodiments of the disclosure are not limited thereto. The multi-layered inorganic layers may have a structure in which layers including silicon nitride and silicon oxide are alternately stacked.

A connection electrode CNE may be disposed between the sixth transistor T6 and the light emitting element OLED-R. The connection electrode CNE may electrically connect the sixth transistor T6 to the light emitting element OLED-R. The connection electrode CNE may include a first connection electrode CNE1 and a second connection electrode CNE2 disposed on the first connection electrode CNE1.

The first connection electrode CNE1 may be disposed on the fifth insulating layer INS5, and may be electrically connected to the sixth drain region D6 through a first contact-hole CH1 defined in the first to fifth insulating layers INS1 to INS5. A sixth insulating layer INS6 may be disposed on the fifth insulating layer INS5 to cover the first connection electrode CNE1.

The second connection electrode CNE2 may be disposed on the sixth insulating layer INS6. The second connection electrode CNE2 may be electrically connected to the first connection electrode CNE1 through a second contact-hole CH2 defined in the sixth insulating layer INS6.

The second power line PL2 may be disposed on the sixth insulating layer INS6 and may be covered by a seventh insulating layer INS7. A portion of the second power line PL2 may be disposed in the second light emitting region PXA-R. The second power line PL2 and the second connection electrode CNE2 may be patterned by the same process line and may include the same material.

The seventh insulating layer INS7 may be disposed on the sixth insulating layer INS6 to cover the second connection electrode CNE2 and a second power line PL2. The sixth and seventh insulating layers INS6 and INS7 may include an organic material.

The pixel defining layer PDL may be disposed on the seventh insulating layer INS7. An opening PDL-OP which exposes at least a portion of the first electrode AE-R may be defined in the pixel defining layer PDL. The pixel defining layer PDL may include an organic material. The pixel defining layer PDL may have a predetermined color, but is not limited to any one embodiment.

The first common layer CL-R and the second electrode CE which are included in the light emitting element OLED-R may be disposed on the pixel defining layer PDL.

The thin film encapsulation layer TFE may be disposed on the light emitting element OLED-R to cover the light emitting element OLED-R. The thin film encapsulation layer TFE may be disposed in the entire region of the display region DA. The thin film encapsulation layer TFE may include inorganic films and an organic film disposed between the inorganic films, and is not limited to any one embodiment.

FIG. 7 illustrates a schematic cross-sectional view of the normal region NA in the partition wall WL disposed in the non-light emitting region NPXA. FIG. 8 illustrates a schematic cross-sectional view of the contact region CA in the partition wall WL disposed in the non-light emitting region NPXA.

Referring to FIG. 7 and FIG. 8, the partition wall WL according to an embodiment may include a first insulating pattern IN1, a second insulating pattern IN2, a first partition wall pattern W1, and a second partition wall pattern W2. The first partition wall pattern W1 and the second partition wall pattern W2 disposed in the normal region NA may be defined as a normal partition wall layer WA-N, and the first partition wall pattern W1 and the second partition wall pattern W2 disposed in the contact region CA may be defined as a contact partition wall layer WA-C. The normal partition wall layer WA-N and the contact partition wall layer WA-C may be substantially one connected pattern, and will be described separately for convenience of description. Firstly, the partition wall WL commonly applied will be described.

The first insulating pattern IN1 may be disposed on a pixel defining layer PDL. The first insulating pattern IN1 may include an inorganic material. The second insulating pattern IN2 may be disposed on the first insulating pattern IN1. The second insulating pattern IN2 may include an inorganic material different from that of the first insulating pattern IN1.

For example, the first insulating pattern IN1 may include at least one of indium zinc oxide, indium gallium zinc oxide, or indium tin oxide, and the second insulating pattern IN2 may include at least one of silicon oxide, silicon oxynitride, or silicon nitride.

The first insulating pattern IN1 may be a component for disconnecting a P-type hole injection layer among layers included in a first common layer CL-G1. Therefore, the thickness of the first insulating pattern IN1 may be greater than the thickness of the P-type hole injection layer among the layers included in the first common layer CL-G1.

On a cross-section, a width of the second insulating pattern IN2 may be greater than a width of the first insulating pattern IN1. The width difference may be formed due to a difference in etch rate with respect to an etchant between the first insulating pattern IN1 and the second insulating pattern IN2.

A step may be formed in a portion other than a portion of the second insulating pattern IN2 which overlaps the first partition wall pattern W1. Therefore, the thickness of the portion of the second insulating pattern IN2 which overlaps the first partition wall pattern W1 may be greater than a thickness of a portion of the second insulating pattern IN2 which is exposed from the first partition wall pattern W1.

The common layers CL-G1 and CL-B of FIG. 7 and CL-G1 and CL-G2 of Fig. 8 included in different pixels may be disconnected from each other with the partition wall WL interposed therebetween by the first insulating pattern IN1 and the second insulating pattern IN2, and the disconnected common layers CL-G1 and CL-B of FIG. 7 and CL-G1 and CL-G2 of Fig. 8 may be in contact with side surfaces of the first insulating pattern IN1 and the second insulating pattern IN2. However, embodiments of the disclosure are not limited thereto, and the disconnected common layers CL-G1 and CL-B of FIG. 7 and CL-G1 and CL-G2 of Fig. 8 may be in contact with side surfaces N1-S and C1-S of the first partition wall pattern W1, but are not limited to any one embodiment.

The first partition wall pattern W1 may be disposed on the second insulating pattern IN2. The first partition wall pattern W1 may include a metal. For example, the first partition wall pattern W1 may include aluminum. Since the first partition wall pattern W1 includes aluminum, the side surfaces N1-S and C1-S of the first partition wall pattern W1 may be oxidized to have no conductivity (or not to be conductive). Therefore, the side surfaces N1-S and C1-S of the first partition wall pattern W1 may include non-conductor regions N1-O and C1-O.

The second partition wall pattern W2 may be disposed on the first partition wall pattern W1. The second partition wall pattern W2 may include a metal different from that of the first partition wall pattern W1. For example, the second partition wall pattern W2 may include titanium.

A thickness of the first partition wall pattern W1 may be greater than a thickness of the second partition wall pattern W2, and a width of the first partition wall pattern W1 may be smaller than a width of the second partition wall pattern W2. A portion of the second partition wall pattern W2 may protrude from the first partition wall pattern W1 to be exposed from the first partition wall pattern W1. Therefore, lower surfaces N2-B and C2-B of the second partition wall pattern W2 may be exposed from the first partition wall pattern W1. The above exposure may be due to a difference in etch rate with respect to an etchant between the first partition wall pattern W1 and the second partition wall pattern W2. The first partition wall pattern W1 and the second partition wall pattern W2 may be defined to have a tip structure.

The second electrode CE may be extended from the second light emitting region PXA-R illustrated in FIG. 6 to the non-light emitting region NPXA to be disposed on the partition wall WL. The second electrode CE overlapping the partition wall WL may be in contact with the side surfaces N1-S and C1-S of the first partition wall pattern W1, the lower surfaces N2-B and C2-B of the second partition wall pattern W2 which are exposed from the first partition wall pattern W1, and side surfaces N2-S and C2-S of the second partition wall pattern W2.

As described above, since the side surfaces N1-S and C1-S of the first partition wall pattern W1 are oxidized to include the non-conductor regions N1-O and C1-O, a portion of the second electrode CE covering the partition wall WL may be electrically connected to another portion of the second electrode CE through the lower surfaces N2-B and C2-B of the second partition wall pattern W2 which are exposed from the first partition wall pattern W1 and through an inner portion of the first partition wall pattern W1, and may be electrically connected to each other by receiving a signal from the second power line PL2.

A first thickness TH1 of the second electrode CE disposed on the common layers CL-G1 and CL-B may be greater than a second thickness TH2 of the second electrode CE surrounding the partition wall WL. The second thickness TH2 may have a thickness of about 20% to about 25% with respect to the first thickness TH1.

A dummy pattern CL-P may be disposed on the second partition wall pattern W2. The dummy pattern CL-P may be covered by the second electrode CE. The dummy pattern CL-P may be formed by the same process as the common layers CL-G1 and CL-B, and may include the same material as the common layers CL-G1 and CL-B. The common layers CL-G1 and CL-B may be disconnected on the second partition wall pattern W2 by a tip structure of the partition wall WL, and a disconnected portion of the common layers CL-G1 and CL-B may be defined as the common layers CL-G1 and CL-B.

Referring to FIG. 7 and FIG. 8, an upper surface N1-U of the first partition wall pattern W1 in the normal region NA and an upper surface C1-U of the first partition wall pattern W1 in the contact region CA may have different shapes from each other.

The upper surface N1-U of the first partition wall pattern W1 may be flat in the normal region NA. Accordingly, a lower surface N2-B and an upper surface N2-U of the second partition wall pattern W2 disposed on the first partition wall pattern W1 may have a flat shape corresponding to the upper surface N1-U of the first partition wall pattern W1.

In the contact region CA, the upper surface C1-U of the first partition wall pattern W1 may have a concave shape in a direction from the upper surface C1-U of the first partition wall pattern W1 to a lower surface of the first partition wall pattern W1. This may be a shape formed by filling the first partition wall pattern W1 with an opening OP and the contact-hole CNT in the contact region CA. Accordingly, the lower surface C2-B and an upper surface C2-U of the second partition wall pattern W2 disposed on the first partition wall pattern W1 may have a shape corresponding to the upper surface C1-U of the first partition wall pattern W1.

Referring to FIG. 8, the contact-hole CNT may be defined in the contact region CA. The contact-hole CNT may be defined by a first contact-hole I-C through which the seventh insulating layer INS7 (an interlayer insulating layer) overlapping the second power line PL2 passes, and a second contact-hole P-C through which the pixel defining layer PDL overlapping the first contact-hole I-C passes.

The opening OP may be defined in the first insulating pattern IN1 and the second insulating pattern IN2 in the contact region CA. The opening OP may overlap the contact-hole CNT, and may expose the second power line PL2 together with the contact-hole CNT. The opening OP may be defined by a first opening I-OP1 which passes through the first insulating pattern IN1 and a second opening I-OP2 which overlaps the first opening I-OP1 to expose the second power line PL2 and through which the second insulating pattern IN2 passes.

The second insulating pattern IN2 may cover a side surface of the seventh insulating layer INS7 which defines the first contact-hole I-C and a side surface of the pixel defining layer PDL which defines the second contact-hole P-C. The second insulating pattern IN2 may cover an upper surface of the pixel defining layer PDL exposed from the first insulating pattern IN1 by the first opening I-OP1. However, the shape of the second insulating pattern IN2 is not limited thereto.

The first partition wall pattern W1 may be electrically connected to the second power line PL2 through the opening OP and the contact-hole CNT in the contact region CA. The second power line PL2 may include metal layers stacked in three layers. A lower layer and an upper layer may include titanium, and a middle layer may include aluminum.

As illustrated in FIG. 5A, the second electrode CE may be commonly disposed in one pixel unit PXU, and may be electrically connected to the second power line PL2 through the lower surfaces N2-B and C2-B of the second partition wall pattern W2, the side surfaces N2-S and C2-S thereof, and the inner portion of the first partition wall pattern W1.

The second electrode CE may be electrically connected to the second power line PL2 through the partition wall WL in the display region DA (see FIG. 1A), thereby preventing a voltage drop phenomenon to provide a constant voltage to pixels. Since the connection between the second electrode CE and the second power line PL2 is achieved in the display region DA (see FIG. 1A), an unnecessary space for connecting the second electrode CE and the second power line PL2 may be reduced in the non-display region NDA. The pixel units PXU having different resolutions may be individually driven.

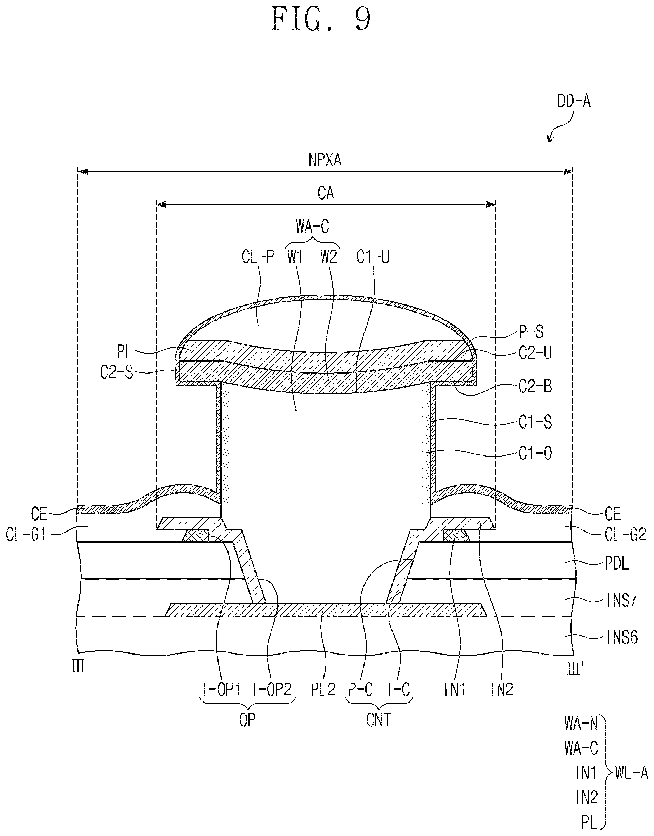

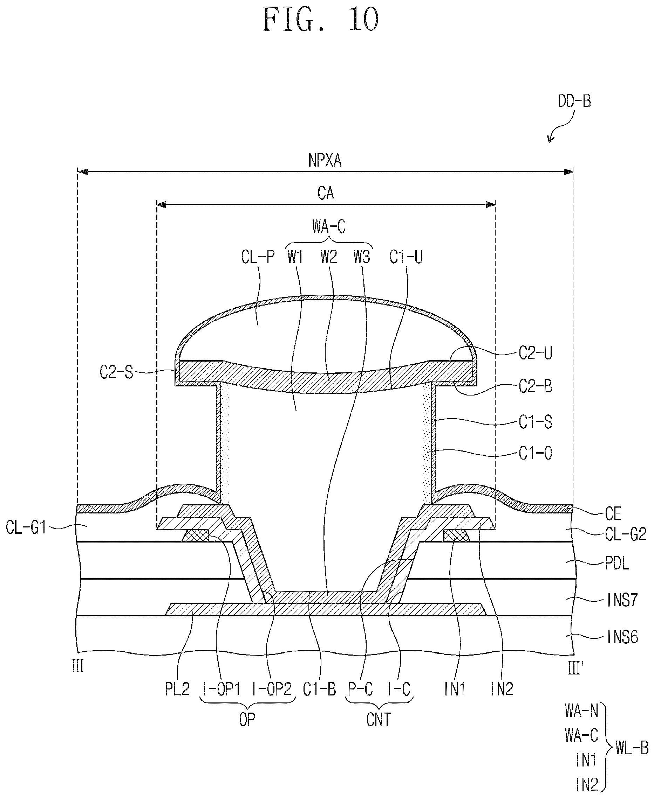

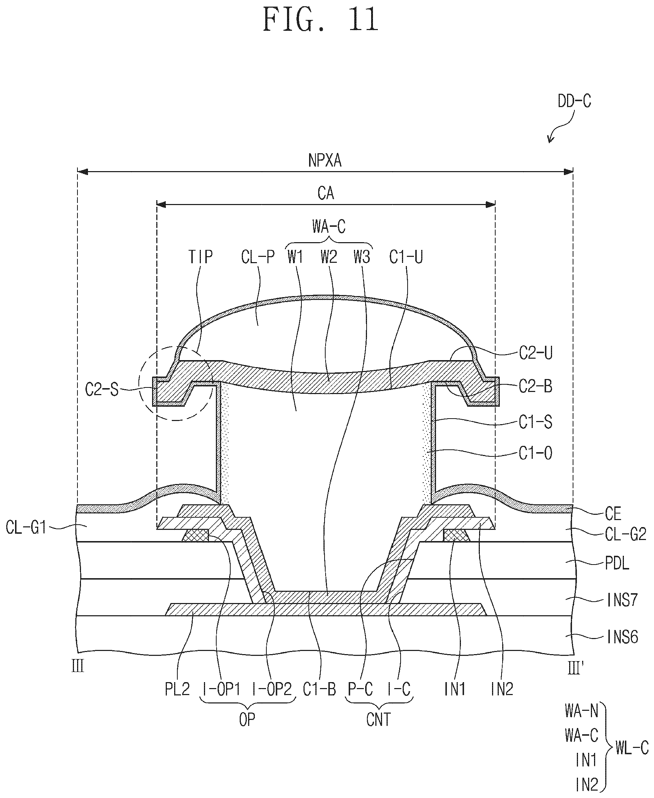

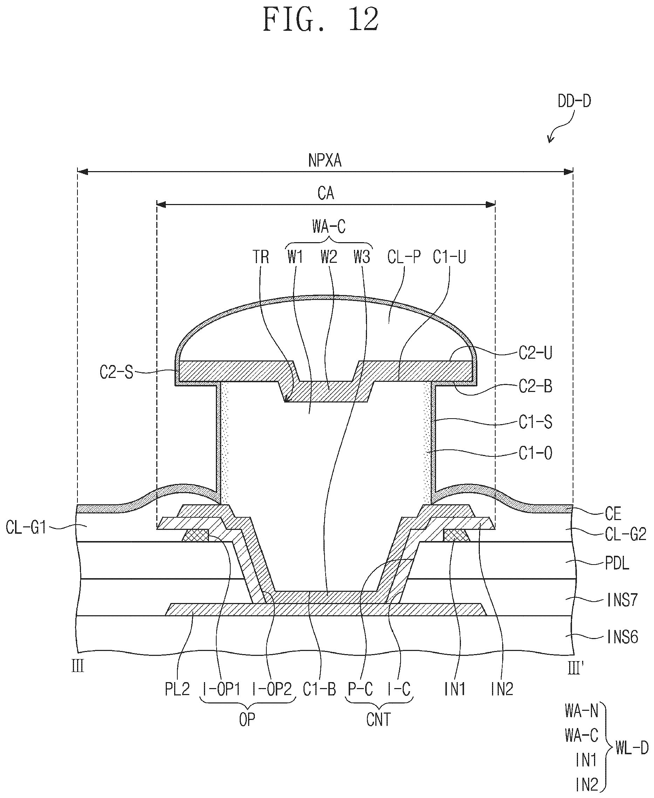

FIG. 9 is a schematic cross-sectional view of a partition wall overlapping a contact region according to an embodiment of the disclosure. FIG. 10 is a schematic cross-sectional view of a partition wall overlapping a contact region according to an embodiment of the disclosure. FIG. 11 is a schematic cross-sectional view of a partition wall overlapping a contact region according to an embodiment of the disclosure. FIG. 12 is a schematic cross-sectional view of a partition wall overlapping a contact region according to an embodiment of the disclosure. The same/similar reference numerals are used for the same/similar components as those described with reference to FIG. 1A to FIG. 8, and redundant descriptions thereof are omitted. FIG. 9 to FIG. 12 are embodiments illustrating a schematic cross-sectional view of a contact partition wall layer disposed in a contact region CA corresponding to FIG. 8. Hereinafter, embodiments about contact partition wall layers described may be commonly applied to the normal partition wall layer WA-N (see FIG. 7) disposed in the normal region NA (see FIG. 7) described with reference to FIG. 7.

Referring to FIG. 9, an electronic device DD-A according to an embodiment may include a partition wall WL-A disposed in a non-light emitting region NPXA. The partition wall WL-A may include a normal partition wall layer WA-N, a contact partition wall layer WA-C, a first insulating pattern IN1, a second insulating pattern IN2, and a protective layer PL. Each of the normal partition wall layer WA-N and the contact partition wall layer WA-C may include a first partition wall pattern W1 and a second partition wall pattern W2.

FIG. 9 illustrates the contact partition wall layer WA-C disposed in the contact region CA corresponding to FIG. 8. The description of the contact partition wall layer WA-C may be commonly applied to the normal partition wall layer WA-N disposed in the normal region NA (see FIG. 7), and a redundant description thereof will be omitted.

The first insulating pattern IN1 may be disposed on a pixel defining layer PDL. The first insulating pattern IN1 may include an inorganic material. The second insulating pattern IN2 may be disposed on the first insulating pattern IN1. The second insulating pattern IN2 may include an inorganic material different from that of the first insulating pattern IN1.

The first partition wall pattern W1 may be disposed on the second insulating pattern IN2. The first partition wall pattern W1 may include aluminum. Side surfaces N1-S and C1-S of the first partition wall pattern W1 may be oxidized to have no conductivity (or not to be conductive). Therefore, the side surfaces N1-S and C1-S of the first partition wall pattern W1 may include non-conductor regions N1-O and C1-O.

The second partition wall pattern W2 may be disposed on the first partition wall pattern W1. The second partition wall pattern W2 may include titanium.

The partition wall WL-A according to the embodiment may further include a protective layer PL. The protective layer PL may be disposed on an upper surface C2-U of the second partition wall pattern W2. The protective layer PL may be disposed on the second partition wall pattern W2 to prevent the second partition wall pattern W2 from being damaged in a subsequent process.

The protective layer PL may include an inorganic material. For example, the protective layer PL may include at least one of silicon nitride and silicon oxide.

The second electrode CE may be extended from the second light emitting region PXA-R illustrated in FIG. 6 to the non-light emitting region NPXA to be disposed on the partition wall WL-A. The second electrode CE overlapping the partition wall WL-A may be in contact with the side surface C1-S of the first partition wall pattern W1, the lower surface C2-B of the second partition wall pattern W2 exposed from the first partition wall pattern W1, the side surface C2-S of the second partition wall pattern W2, and a side surface P-S of the protective layer PL.

Since the protective layer PL is disposed on the second partition wall pattern W2, the partition wall WL-A having a robust tip structure may be provided.

In the contact region CA, an upper surface C1-U of the first partition wall pattern W1 may have a concave shape in a direction from the upper surface C1-U of the first partition wall pattern W1 to a lower surface C1-B of the first partition wall pattern W1. The second partition wall pattern W2 and the protective layer PL which are disposed on the first partition wall pattern W1 may have a concave shape corresponding to an upper surface N1-U of the first partition wall pattern W1.

In the contact region CA, a contact-hole CNT including a first contact-hole I-C through which the seventh insulating layer INS7 (the interlayer insulating layer) passes and a second contact-hole P-C through which a pixel defining layer PDL overlapping the first contact-hole I-C passes may be defined.

In the contact region CA, an opening OP including a first opening I-OP1 overlapping the contact-hole CNT and through which the first insulating pattern IN1 passes and a second opening I-OP2 overlapping the first opening I-OP1 to expose a second power line PL2 and through which the second insulating pattern IN2 passes may be defined.

In the contact region CA, the first partition wall pattern W1 may be in contact with the second power line PL2 through the opening OP and the contact-hole CNT.

Referring to FIG. 10, an electronic device DD-B according to an embodiment may include a partition wall WL-B disposed in a non-light emitting region NPXA. The partition wall WLB may include a normal partition wall layer WA-N, a contact partition wall layer WA-C, a first insulating pattern IN1, and a second insulating pattern IN2. Each of the normal partition wall layer WA-N and the contact partition wall layer WA-C may include a first partition wall pattern W1, a second partition wall pattern W2, and a third partition wall pattern W3.

FIG. 10 illustrates the contact partition wall layer WA-C of the partition wall WL-B, which is disposed in the contact region CA corresponding to FIG. 8. The description of the contact partition wall layer WA-C may be commonly applied to the normal partition wall layer WA-N disposed in the normal region NA (see FIG. 7), and a redundant description thereof will be omitted.

The first insulating pattern IN1 may be disposed on a pixel defining layer PDL. The second insulating pattern IN2 may be disposed on the first insulating pattern IN1.

The first partition wall pattern W1 is disposed on the second insulating pattern IN2. The first partition wall pattern W1 may include aluminum. Side surfaces N1-S and C1-S of the first partition wall pattern W1 may be oxidized to have no conductivity (or not to be conductive). Therefore, the side surfaces N1-S and C1-S of the first partition wall pattern W1 may include non-conductor regions N1-O and C1-O.

The second partition wall pattern W2 may be disposed on the first partition wall pattern W1. The second partition wall pattern W2 may include titanium.

The partition wall WL-B according to the embodiment may further include a third partition wall pattern W3. The third partition wall pattern W3 may be disposed between the first partition wall pattern W1 and the second insulating pattern IN2 and the second power line PL2. The third partition wall pattern W3 may include the same material as the first partition wall pattern W1. Therefore, the third partition wall pattern W3 may include titanium.

The third partition wall pattern W3 may be disposed in an opening OP and a contact-hole CNT so as to be in contact with a second power line PL2. For example, the third partition wall pattern W3 may be in contact with an upper surface of the second insulating pattern IN2, a side surface of the second insulating pattern IN2 defining a second opening I-OP2, and the second power line PL2. The third partition wall pattern W3 may have a shape corresponding to that of a lower surface C1-B of the first partition wall pattern W1.

The second electrode CE may be disposed on the partition wall WL-B. The second electrode CE overlapping the partition wall WL-B may be in contact with a side surface C1-S of the first partition wall pattern W1, a lower surface C2-B of the second partition wall pattern W2 exposed from the first partition wall pattern W1, and a side surface C2-S of the second partition wall pattern W2.

Common layers CL-G1 and CL-G2 may be in contact with the first and second insulating patterns IN1 and IN2 and the third partition wall pattern W3.

In the contact region CA, an upper surface C1-U of the first partition wall pattern W1 may have a concave shape in a direction from the upper surface C1-U of the first partition wall pattern W1 to a lower surface of the first partition wall pattern W1. The second partition wall pattern W2 disposed on the first partition wall pattern W1 may have a concave shape corresponding to an upper surface N1-U of the first partition wall pattern W1.

In the contact region CA, the third partition wall pattern W3 may be in contact with the second power line PL2 through the opening OP and the contact-hole CNT.

FIG. 11 will be described focusing on differences from FIG. 10. Referring to FIG. 11, an electronic device DD-C according to an embodiment may include a partition wall WL-C disposed in a non-light emitting region NPXA. The partition wall WL-C may include a normal partition wall layer WA-N, a contact partition wall layer WA-C, a first insulating pattern IN1, and a second insulating pattern IN2. Each of the normal partition wall layer WA-N and the contact partition wall layer WA-C may include a first partition wall pattern W1, a second partition wall pattern W2, and a third partition wall pattern W3.

A portion of the second partition wall pattern W2 exposed from the first partition wall pattern W1 may include a tip portion TIP bent in a downward direction.

As the second partition wall pattern W2 includes the tip portion TIP, the common layers CL-G1 and CL-G2 may be more readily disconnected in the partition wall WL.

FIG. 12 will be described focusing on differences from FIG. 10. Referring to FIG. 12, an electronic device DD-D according to an embodiment may include a partition wall WL-D disposed in a non-light emitting region NPXA. The partition wall WL-D may include a normal partition wall layer WA-N, a contact partition wall layer WA-C, a first insulating pattern IN1, and a second insulating pattern IN2. Each of the normal partition wall layer WA-N and the contact partition wall layer WA-C may include a first partition wall pattern W1, a second partition wall pattern W2, and a third partition wall pattern W3.

A trench TR may be defined in the first partition wall pattern W1. The trench TR may be defined by being recessed in a direction from an upper surface C1-U of the first partition wall pattern W1 toward a lower surface C1-B of the first partition wall pattern W1. The trench TR may be defined as an empty space, and the trench TR may have an inverted trapezoidal shape on a cross-section.

The shape of the trench TR may be formed by filling the first partition wall pattern W1 with a contact-hole CNT in a contact region CA. The second partition wall pattern W2 may be disposed on the first partition wall pattern W1 to correspond to the shape of the trench TR.

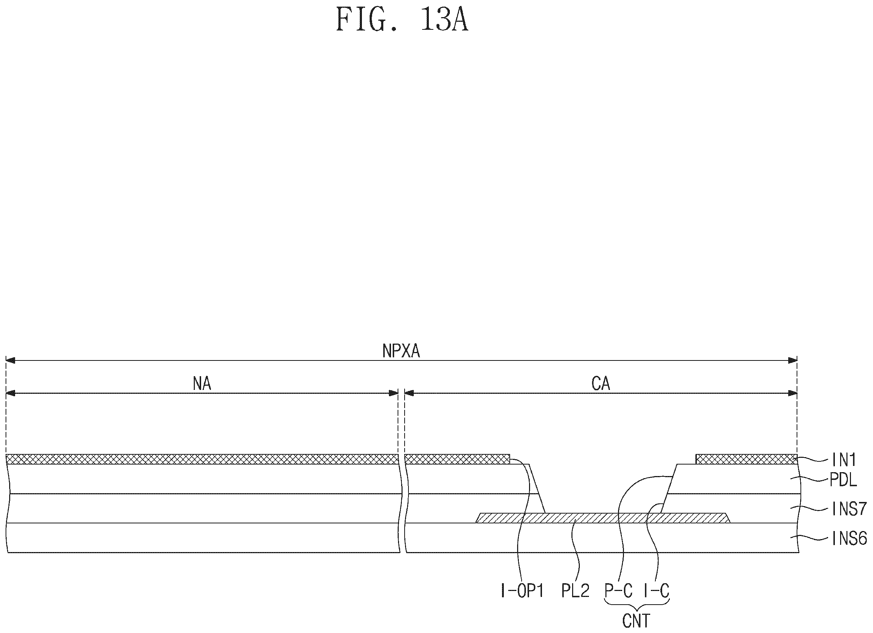

FIG. 13A to FIG. 13G are schematic cross-sectional views illustrating a method for manufacturing a display panel according to an embodiment of the disclosure. FIG. 13A to FIG. 13G illustrate a method for forming the normal partition wall layer WA-N disposed in the normal region NA described with reference to FIG. 7 and the contact partition wall layer WA-C disposed in the contact region CA described with reference to FIG. 8. Among the components described with reference to FIG. 13A to FIG. 13G, components below the sixth insulating layer INS6 are omitted.

Referring to FIG 13A, a method for manufacturing a display panel according to an embodiment may include forming a second power line PL2 in the contact region CA. The second power line PL2 may include metal layers stacked in three layers. A lower layer and an upper layer may include titanium, and a middle layer may include aluminum.

Thereafter, the method may include forming a seventh insulating layer INS7 on the sixth insulating layer INS6, forming a pixel defining layer PDL on the seventh insulating layer INS7, and forming a first insulating pattern IN1 on the pixel defining layer PDL.

The first insulating pattern IN1 may include at least one of indium zinc oxide, indium gallium zinc oxide, or indium tin oxide.

A first contact-hole I-C exposing the second power line PL2 may be formed in the seventh insulating layer INS7. A second contact-hole P-C overlapping the first contact-hole I-C may be formed in the pixel defining layer PDL. The first contact-hole I-C and the second contact-hole P-C may be defined as a contact-hole CNT. A process of forming the first contact-hole I-C and the second contact-hole P-C may be performed by a photoresist process.

A first opening I-OP1 overlapping the contact-hole CNT may be formed in the first insulating pattern IN1. A process of forming the first opening I-OP1 may be performed by a wet etching process.

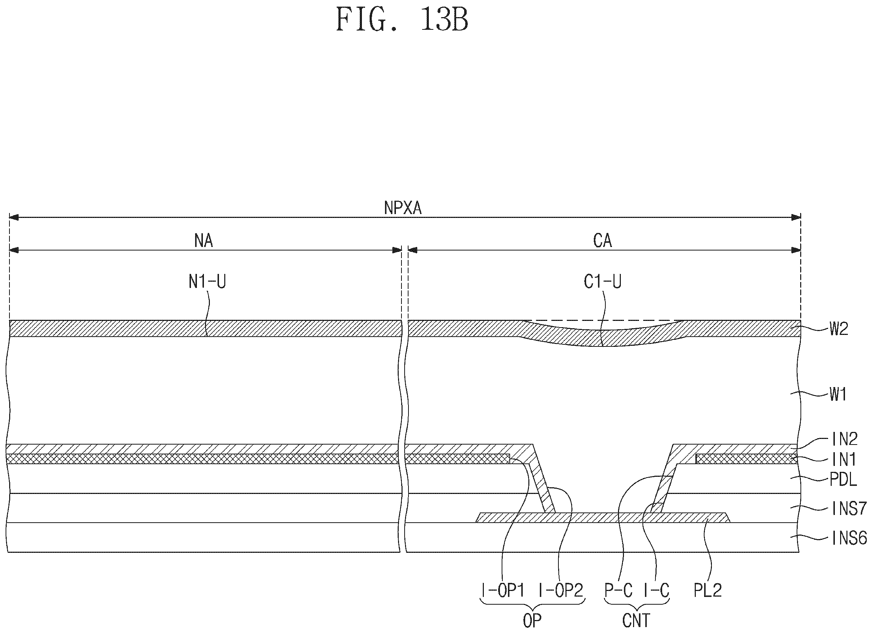

Thereafter, referring to FIG. 13B, the method for manufacturing a display panel according to an embodiment may include forming a second insulating pattern IN2, forming a first partition wall pattern W1, and forming a second partition wall pattern W2.

The second insulating pattern IN2 may be formed on the first insulating pattern IN1 to cover the pixel defining layer PDL and the seventh insulating layer INS7. The first insulating pattern IN1 may include at least one of silicon oxide, silicon oxynitride, or silicon nitride.

A second opening I-OP2 overlapping a contact-hole CNT and the first opening I-OP1 and exposing a second power line PL2 may be formed in the second insulating pattern IN2. The second opening I-OP2 may be formed by a dry etching process. The first opening I-OP1 and the second opening I-OP2 may be defined as an opening OP.

The first partition wall pattern W1 may be formed on the second insulating pattern IN2 and partially on the second power line PL2. The first partition wall pattern W1 may include aluminum. In the contact region CA, the first partition wall pattern W1 may be in contact with the second power line PL2 through the opening OP and the contact-hole CNT.

The second partition wall pattern W2 may be formed on the first partition wall pattern W1. The second partition wall pattern W2 may include titanium. A thickness of the second partition wall pattern W2 may be smaller than a thickness of the first partition wall pattern W1.

In the contact region CA, an upper surface C1-U of the first partition wall pattern W1 may have a concave shape in a direction from the upper surface C1-U of the first partition wall pattern W1 to a lower surface of the first partition wall pattern W1. This may be a shape formed by filling the first partition wall pattern W1 with an opening OP and the contact-hole CNT in the contact region CA. Accordingly, the second partition wall pattern W2 disposed on the first partition wall pattern W1 may have a shape corresponding to an upper surface N1-U of the first partition wall pattern W1.

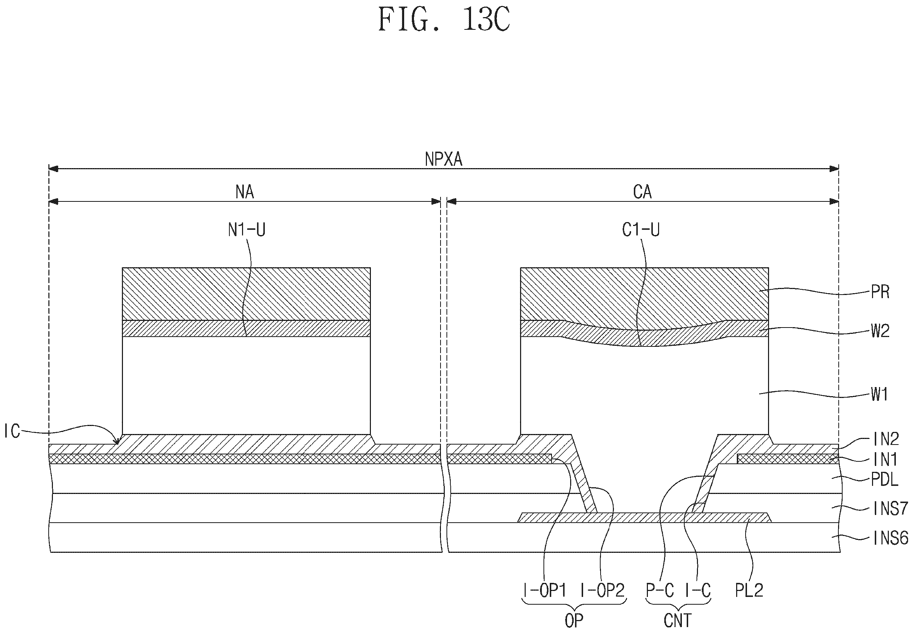

Thereafter, referring to FIG. 13C, the method for manufacturing a display panel may include subjecting the first and second partition wall patterns W1 and W2 to primary patterning. The primary patterning may be performed by a photo process using a photoresist layer PR as a mask. Only the first and second partition wall patterns W1 and W2 overlapping the photoresist layer PR may remain by the photo process.

At this time, a step IC may be formed in a portion other than a portion of the first insulating pattern IN1 which overlaps the first and second partition wall patterns W1 and W2. This may be because a portion of the second insulating pattern IN2 is removed together in a process of etching the first and second partition wall patterns W1 and W2 removed in the photo process.

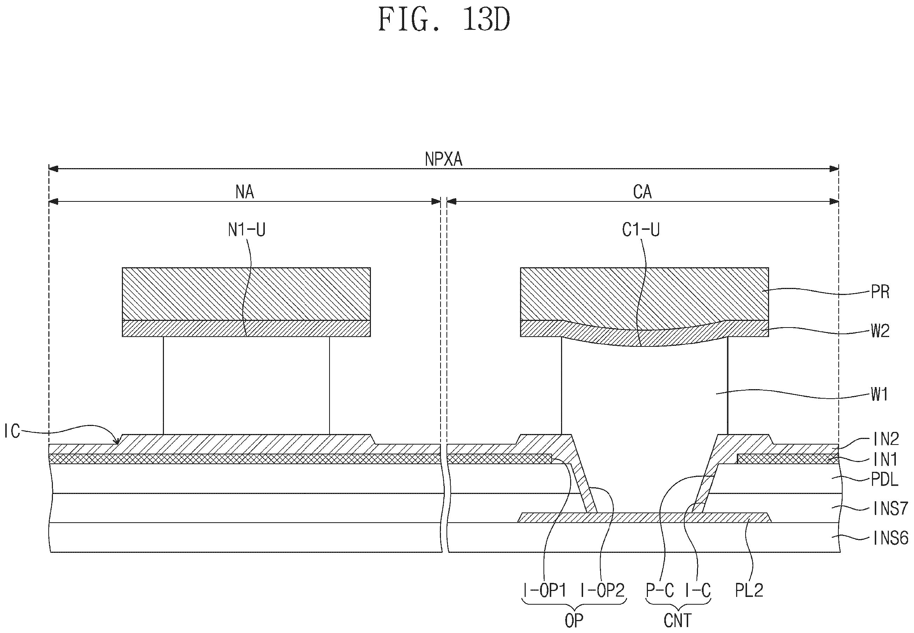

Thereafter, referring to FIG. 13D, the method for manufacturing a display panel according to an embodiment may include subjecting the second partition wall pattern W2 to secondary patterning. The secondary patterning may be performed by a wet etching process. By the secondary patterning, a width of the first partition wall pattern W1 may become smaller than a width of the second partition wall pattern W2. A tip structure may be formed as a portion of the second partition wall pattern W2 protrudes from the first partition wall pattern W1 to be exposed from the first partition wall pattern W1.

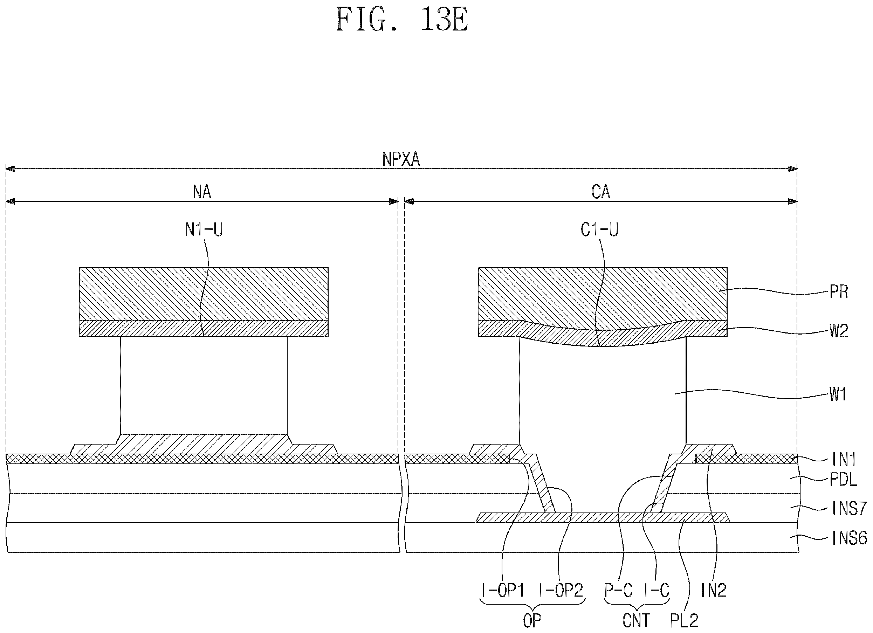

Thereafter, referring to FIG. 13E, the method for manufacturing a display panel according to an embodiment may include patterning the second insulating pattern IN2. The patterning of the second insulating pattern IN2 may be performed by a dry etching process. The second insulating pattern IN2 may be patterned to remove portions other than a portion overlapping the first partition wall pattern W1.

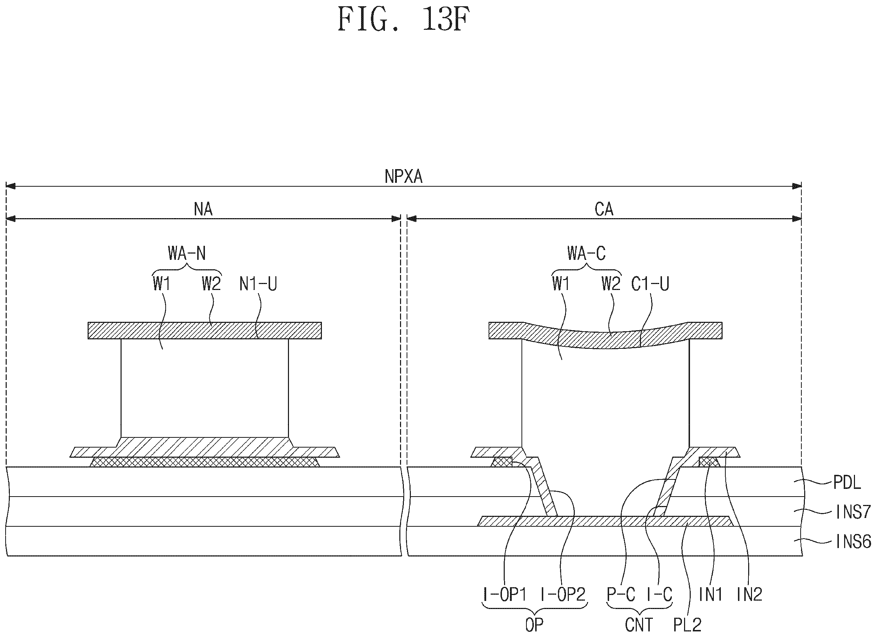

Thereafter, referring to FIG. 13F, the method for manufacturing a display panel according to an embodiment may include patterning the first insulating pattern IN1. The patterning of the first insulating pattern IN1 may be performed by a wet etching process. The first insulating pattern IN1 may be patterned to remove portions other than a portion overlapping the second insulating wall pattern IN2.

In one direction, the width of the first insulating pattern IN1 may be smaller than the width of the second insulating pattern IN2.

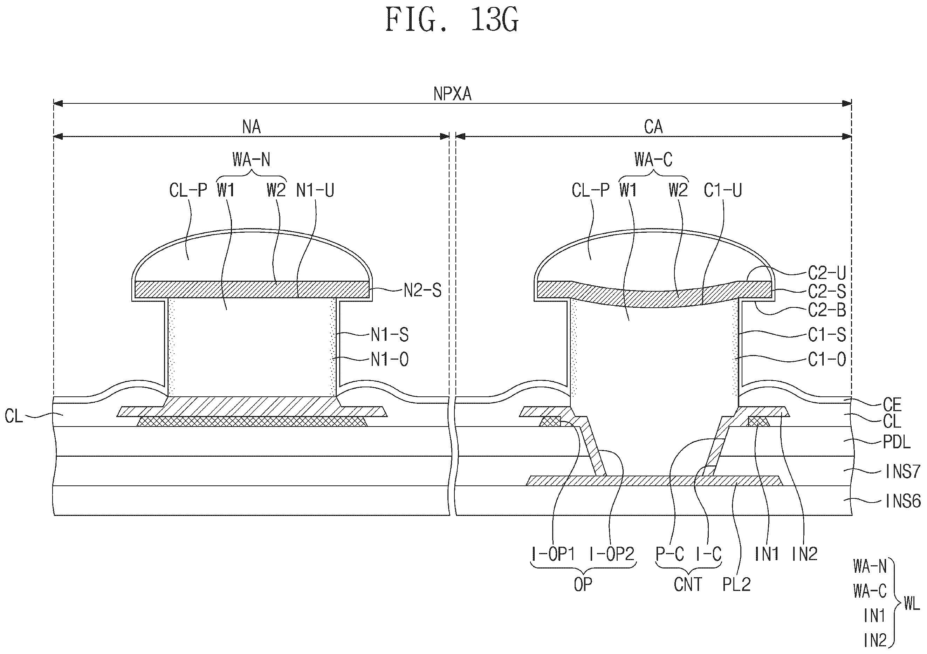

Thereafter, referring to FIG. 13G, the method for manufacturing a display panel according to an embodiment may include forming a common layer CL and forming a second electrode CE. The common layer CL may include a hole injection layer, a hole transport layer, a light emitting layer, an electron transport layer, and an electron injection layer.

A P-type hole injection layer among the layers included in the common layer CL may be disconnected by the first insulating pattern IN1. Therefore, a thickness of the first insulating pattern IN1 may be greater than a thickness of the P-type hole injection layer.

The second electrode CE may be extended from the second light emitting region PXA-R illustrated in FIG. 6 to the non-light emitting region NPXA to be disposed on the partition wall WL. The second electrode CE overlapping the partition wall WL may be in contact with the side surfaces N1-S and C1-S of the first partition wall pattern W1, the lower surfaces N2-B and C2-B of the second partition wall pattern W2 which are exposed from the first partition wall pattern W1, and side surfaces N2-S and C2-S of the second partition wall pattern W2.

The side surfaces N1-S and C1-S of the first partition wall pattern W1 may include non-conductor regions N1-O and C1-O which have no conductivity (or not to be conductive). The second electrode CE which covers the partition wall WL may receive a signal from the second power line PL2 through the lower surfaces N2-B and C2-B of the second partition wall pattern W2 which are exposed from the first partition wall pattern W1 and through an inner portion of the first partition wall pattern W1, and may be electrically connected to each other.

A second electrode may be electrically connected to a power line through a partition wall in a display region, thereby preventing a voltage drop phenomenon to provide a constant voltage to pixels. Since the connection between the second electrode and the power line is achieved in the display region, an unnecessary space for connecting the second electrode and a second power line may be reduced in a non-display region. Pixel units having different resolutions may be individually driven.

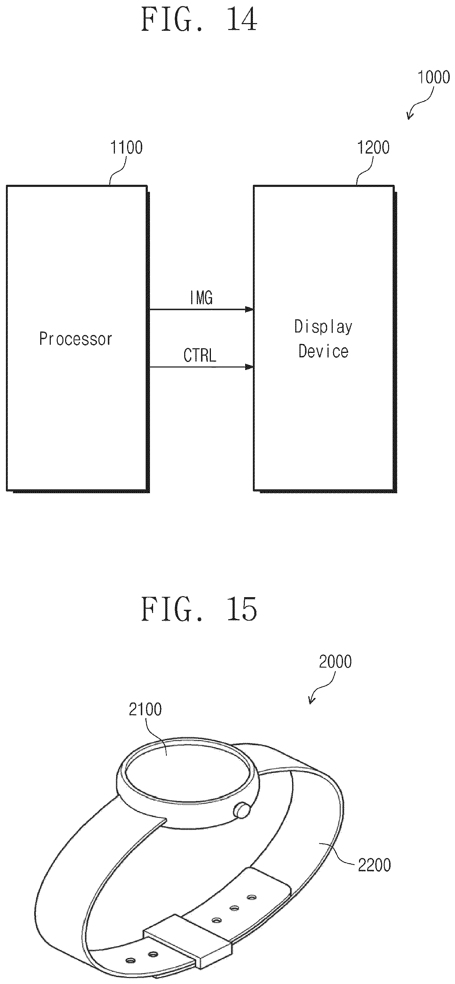

Referring to FIG. 14, the display system 1000 may include a processor 1100 and a display device 1200.

The processor 1100 may perform various tasks and calculations. The processor 1100 may include an application processor, a graphics processor, a microprocessor, a central processing unit (CPU), and the like. The processor 1100 may be electrically connected to other components of the display system 1000 through a bus system to control the other components.

The processor 1100 may transmit image data IMG and a control signal CTRL to the display device 1200. The display device 1200 may display an image based on the image data IMG and the control signal CTRL. The display device 1200 may be similarly configured to the electronic device DD described with reference to FIGS. 1A and 1B.

The display system 1000 may include a computing system providing an image display function, such as a smart watch, a mobile phone, a smart phone, a portable computer, a tablet personal computer (PC), a watch phone, an automotive display, smart glasses, a portable multimedia player (PMP), a navigation device, and an ultra mobile personal computer (UMPC). The display system 1000 may include at least one of a head mounted display (HMD) device, a virtual reality (VR) device, a mixed reality (MR) device, and an augmented reality (AR) device.

Referring to FIG. 15, the display system 1000 of FIG. 14 may be applied to a smart watch 2000 including a display unit 2100 and a strap unit 2200.

The smart watch 2000 may be a wearable electronic device. For example, the smart watch 2000 may have a structure in which the strap unit 2200 is mounted on a user's wrist. Here, the display system 1000 and/or the display device 1200 may be applied to the display unit 2100, and image data including time information may be provided to a user.

As discussed, embodiments may provide an electronic device comprising: a substrate including a display region having light emitting regions and a non-light emitting region disposed between the light emitting regions; a pixel unit including pixels each having a light emitting element, and disposed on the substrate; a power line crossing the pixel unit, and disposed on the substrate; and a partition wall having partition wall openings overlapping the light emitting regions, disposed in the non-light emitting region to surround each of the pixels, and including a first partition wall pattern and a second partition wall pattern disposed on the first partition wall pattern, wherein the partition wall is divided into a contact region in which the partition wall is electrically connected to the power line through a contact-hole, and a normal region other than the contact region. A shape of an upper surface of the first partition wall pattern in the normal region may be different from a shape of an upper surface of the first partition wall pattern in the contact region.

The partition wall may include a metal. In particular, the first partition wall pattern and the second partition wall pattern may be mad of metal.

The first partition wall pattern may be electrically connected to the power line through the opening and the contact-hole in the contact region.

A common electrode (e.g. a second electrode) may be provided for the pixels in the pixel unit. The common electrode may be electrically connected to the power line through the partition wall. The common electrode may be electrically connected to the second partition wall pattern.

The common electrode may cover side surfaces of the first partition wall pattern, and a portion of the second partition wall pattern. The side surfaces of the first partition wall pattern may be non-conductive.

A dummy pattern may be disposed on the second partition wall pattern. The dummy pattern may be covered by the common electrode.

The partition wall may include a first insulating pattern, a second insulating pattern, the first partition wall pattern, and the second partition wall pattern.

The first insulating pattern may be disposed on a pixel defining layer. The first insulating pattern may include an inorganic material. The second insulating pattern may be disposed on the first insulating pattern. The second insulating pattern may include an inorganic material different from that of the first insulating pattern. The first partition wall pattern may be disposed on the second insulating pattern.

The first partition wall pattern may include a metal. For example, the first partition wall pattern may include aluminum. If the first partition wall pattern includes aluminum, the side surfaces of the first partition wall pattern may be oxidized to have no conductivity (or not to be conductive). Therefore, the side surfaces of the first partition wall pattern may include non-conductor regions.

The second partition wall pattern may include a metal different from that of the first partition wall pattern. For example, the second partition wall pattern may include titanium.

A thickness of the first partition wall pattern may be greater than a thickness of the second partition wall pattern, and a width of the first partition wall pattern may be smaller than a width of the second partition wall pattern. A portion of the second partition wall pattern may protrude from the first partition wall pattern to be exposed from the first partition wall pattern. Therefore, lower surfaces of the second partition wall pattern may be exposed from the first partition wall pattern.

The upper surface of the first partition wall pattern may be flat in the normal region. Accordingly, a lower surface and an upper surface of the second partition wall pattern disposed on the first partition wall pattern may have a flat shape corresponding to the upper surface of the first partition wall pattern.

In the contact region, the upper surface of the first partition wall pattern may have a concave shape in a direction from the upper surface of the first partition wall pattern to a lower surface of the first partition wall pattern. This may be a shape formed by filling the first partition wall pattern with an opening and the contact-hole in the contact region. Accordingly, the lower surface and an upper surface of the second partition wall pattern disposed on the first partition wall pattern may have a shape corresponding to the upper surface of the first partition wall pattern.

The contact-hole may be defined by a first contact-hole through which an interlayer insulating layer overlapping the power line passes, and a second contact-hole through which the pixel defining layer overlapping the first contact-hole passes.

The power line may include metal layers stacked in three layers. A lower layer and an upper layer may include titanium, and a middle layer may include aluminum.

The pixel unit according to an embodiment may include first-first, first-second, second, and third pixels. The first-first pixel may provide green light. The first-first light emitting region may have a rhombic shape. The first-second pixel may provide green light like the first-first pixel. The first-second light emitting region may be spaced apart from the first-first light emitting region along a first direction. The first-second light emitting region may have a rhombic shape. The second pixel may provide red light. The second light emitting region may be spaced apart from a third light emitting region along a second direction. The second light emitting region may be spaced apart from the first-first light emitting region along a first diagonal direction, and may be spaced apart from the first-second light emitting region along a second diagonal direction. The second light emitting region PXA-R may have a rhombic shape. The third pixel may provide blue light. The third light emitting region may be spaced apart from the first-second light emitting region along the first diagonal direction, and may be spaced apart from the first-first light emitting region along the first diagonal direction. The third light emitting region may have a rhombic shape.

The area of the second light emitting region may be larger than the area of the first-first and first-second light emitting regions, and may be smaller than the area of the third light emitting region.

The partition wall may have partition wall openings overlapping the first-first to third light emitting regions. Each of the partition wall openings may have a rhombic shape. The partition wall openings may be defined by side surfaces of partition wall patterns included in the partition wall and including a metal.

The pixel unit according to an embodiment may include first to third light emitting regions. Each of the partition wall openings may have a quadrangular shape. The partition wall openings may be defined by side surfaces of partition wall patterns included in the partition wall and including a metal.

Although the disclosure has been described with reference to preferred embodiments of the disclosure, it will be understood by those skilled in the art that various modifications and changes in form and details may be made therein without departing from the spirit and scope of the disclosure as set forth in the following claims.

Accordingly, the technical scope of the disclosure is not intended to be limited to the contents set forth in the detailed description of the specification, but is intended to be defined by the appended claims.

## Claims

1. An electronic device comprising:
a substrate including a display region having light emitting regions and a non-light emitting region disposed between the light emitting regions;
a pixel unit including pixels each having a light emitting element, and disposed on the substrate;
a power line crossing the pixel unit, and disposed on the substrate; and
a partition wall having partition wall openings overlapping the light emitting regions, disposed in the non-light emitting region to surround each of the pixels, and including a first partition wall pattern and a second partition wall pattern disposed on the first partition wall pattern,
wherein the partition wall is divided into a contact region in which the partition wall is electrically connected to the power line through a contact-hole, and a normal region other than the contact region, and
wherein a shape of an upper surface of the first partition wall pattern in the normal region is different from a shape of an upper surface of the first partition wall pattern in the contact region.

2. The electronic device of claim 1, wherein:
the upper surface of the first partition wall pattern in the contact region has a concave shape in a direction from the upper surface of the first partition wall pattern toward a lower surface of the first partition wall pattern; and
a portion of the second partition wall pattern has a shape corresponding to the shape of the upper surface of the first partition wall pattern.

3. The electronic device of claim 1 or 2, wherein, in the normal region, the upper surface of the first partition wall pattern is flat.

4. The electronic device of any one of claims 1 to 3, wherein
in the contact region, the upper surface of the first partition wall pattern has a trench recessed in a direction from the upper surface of the first partition wall pattern toward a lower surface of the first partition wall pattern,
on a cross-section, the trench has an inverted trapezoidal shape, and
a portion of the second partition wall pattern has a shape corresponding to a shape of the trench.

5. The electronic device of any one of claims 1 to 4, wherein:
the first partition wall pattern comprises aluminum; and
the second partition wall pattern comprises titanium.

6. The electronic device of any one of claims 1 to 5, wherein:
a width of the first partition wall pattern is smaller than a width of the second partition wall pattern, and
a thickness of the first partition wall pattern is greater than a thickness of the second partition wall pattern.

7. The electronic device of any one of claims 1 to 6, wherein
each of the light emitting elements comprises a first electrode, a second electrode disposed on the first electrode, and a common layer disposed between the first electrode and the second electrode, and
the second electrode is commonly disposed in the light emitting elements.

8. The electronic device of claim 7, wherein the second electrode overlapping the partition wall is in contact with a side surface of the first partition wall pattern, a lower surface of the second partition wall pattern exposed from the first partition wall pattern, and a side surface of the second partition wall pattern;
optionally wherein the side surface of the first partition wall pattern is oxidized not to be conductive.

9. The electronic device of claim 8, further comprising:
a dummy pattern disposed on the second partition wall pattern and covered by the second electrode,
wherein the dummy pattern and the common layer includes a same material;
optionally further comprising: a protective layer disposed between a second partition wall and the dummy pattern, wherein the protective layer includes an inorganic material.

10. The electronic device of claim 8 or 9, wherein a portion of the second partition wall pattern exposed from the first partition wall pattern comprises a tip portion bent in a downward direction.

11. The electronic device of any one of claims 8 to 10, wherein a thickness of the second electrode disposed on the common layer is greater than a thickness of the second electrode surrounding the partition wall.

12. The electronic device of any one of claims 1 to 11, wherein the partition wall comprises a first insulating pattern disposed in a lower portion of the first partition wall pattern and a second insulating pattern disposed between the first insulating pattern and the first partition wall pattern, wherein the first insulating pattern and the second insulating pattern include different materials from each other.

13. The electronic device of claim 12, wherein:
the first insulating pattern comprises at least one of indium zinc oxide, indium gallium zinc oxide, or indium tin oxide; and
the second insulating pattern comprises at least one of silicon oxide, silicon oxynitride, or silicon nitride.

14. The electronic device of claim 12 or 13, wherein a width of the first insulating pattern is smaller than a width of the second insulating pattern; and/or
further comprising: a third partition wall pattern disposed between the first partition wall pattern and the second insulating pattern, wherein the third partition wall pattern and the second partition wall pattern includes a same material; and/or
further comprising: an interlayer insulating layer in which the power line is disposed; an inter-insulating layer disposed on the interlayer insulating layer and covering the power line; and a pixel defining layer in which the first insulating pattern is disposed, and openings corresponding to the light emitting regions are defined, and which is disposed on the inter-insulating layer.

15. The electronic device of claim 12 or 13, wherein the contact-hole is defined by a first contact-hole overlapping a portion of the power line and through which an inter-insulating layer passes, and a second contact-hole overlapping the first contact-hole and through which a pixel defining layer passes, and, in the contact region, an opening overlapping the contact-hole is defined in the first insulating pattern and the second insulating pattern;
optionally wherein the first partition wall pattern is disposed in the opening and the contact-hole to be electrically connected to the power line.
